# EUROPEAN PATENT SPECIFICATION

(11) **EP 4 425 550 B1**
(45) Date of publication and mention of the grant of the patent: **05.11.2025**
(21) Application number: 24158575.1
(22) Date of filing: 20.02.2024
(51) Int. Cl.: H10H 29/32, H10H 29/03

(54) **DISPLAY DEVICE**
ANZEIGEVORRICHTUNG
DISPOSITIF D'AFFICHAGE

(30) Priority: 28.02.2023 KR 20230026730
(43) Date of publication of application: 04.09.2024
(73) Proprietor: LG Display Co., Ltd., Seoul 07336 (KR)
(72) Inventor: Ju, SeongHwan, 10845 Gyeonggi-do (KR); Yeo, Gwangmin, 10845 Gyeonggi-do (KR); Lee, Jongchan, 10845 Gyeonggi-do (KR)
(74) Representative: Ter Meer Steinmeister & Partner

(56) References cited:
- US-A1- 2021 091 159
- US-B2- 9 159 285

## Description

This application claims the priority of Korean Patent Application No. 10-2023-0026730 filed on February 28, 2023, in the Korean Intellectual Property Office.

### BACKGROUND

### Field

The present disclosure relates to a display device, and more particularly, to a display device using a light emitting diode (LED).

### Description of the Related Art

As display devices which are used for a monitor of a computer, a television, a cellular phone, or the like, there are an organic light emitting display (OLED) device which is a self-emitting device, a liquid crystal display (LCD) device which requires a separate light source, and the like.

An applicable range of the display device is diversified to personal digital assistants as well as monitors of computers and televisions and a display device with a large display area and a reduced volume and weight is being studied.

Further, recently, a display device including a light emitting diode (LED) is attracting attention as a next generation display device. Since the LED is formed of an inorganic material, rather than an organic material, reliability is excellent so that a lifespan thereof is longer than that of the liquid crystal display device or the organic light emitting display device. Further, the LED has a fast lighting speed, excellent luminous efficiency, and a strong impact resistance so that a stability is excellent and an image having a high luminance can be displayed. Documents US 2021/091159 A1 and US 9 159 285 B2 relate to a display device comprising a repaired defective sub pixel.

### SUMMARY

An object to be achieved by the present disclosure is to provide a display device which easily darkens a sub pixel in which fault occurs.

Another object to be achieved by the present disclosure is to provide a display device which darkens a sub pixel in which fault occurs only by one welding process.

Still another object to be achieved by the present disclosure is to provide a display device which re-darkens a defective sub pixel only by one cutting process.

Still another object to be achieved by the present disclosure is to provide a display device which reduces a damage of a periphery of a welding area by easily performing a welding process with a low power laser.

Still another object to be achieved by the present disclosure is to provide a display device which connects a light emitting diode of a darkened sub pixel to a pixel circuit of a normal sub pixel by one welding process.

Still another object to be achieved by the present disclosure is to provide a display device which easily connects a light emitting diode which is connected to a defective pixel circuit to a normally driven pixel circuit using a reflection plate.

Still another object to be achieved by the present disclosure is to provide a display device which reduces a defect that reflection plates are connected to each other due to static electricity.

Objects of the present disclosure are not limited to the above-mentioned objects, and other objects, which are not mentioned above, can be clearly understood by those skilled in the art from the following descriptions.

The object is solved by the features of the independent claim 1. Preferred embodiments are given in the dependent claims. In the following the term"disclosure" has to be interpreted as "invention".

According to an aspect of the present disclosure, a display device includes a first substrate in which a plurality of sub pixels including at least one defective sub pixel and a plurality of normal sub pixels is defined; a light emitting diode which is disposed in each of the plurality of sub pixels; a plurality of transistors which is disposed in each of the plurality of sub pixels and includes a driving transistor having a source electrode connected to a first electrode of the light emitting diode; a capacitor which includes a plurality of capacitor electrodes connected to a gate electrode and the source electrode of the driving transistor; and a reflection plate which is disposed in each of the plurality of sub pixels and is electrically connected to the first electrode. The capacitor electrodes of the capacitor are in contact with each other in the defective sub pixel.

Accordingly, in the defective sub pixel, the capacitor electrodes are connected to each other to connect the gate electrode and the source electrode of the driving transistor and the defective sub pixel may be easily darkened.

In the following optional features are provided which can be combined with the above mentioned aspect of the disclosure alone in combination or in sub-combination.

In one or more embodiments, in the defective sub pixel, the gate electrode and the source electrode of the driving transistor may be electrically connected through the plurality of capacitor electrodes.

In one or more embodiments, in the plurality of normal sub pixels, the plurality of capacitor electrodes may be spaced apart from each other with an insulating layer therebetween.

In one or more embodiments, among the plurality of normal sub pixels, the reflection plates of one pair of adjacent normal sub pixels may be insulated and the reflection plate of the defective sub pixel may be electrically connected to one of the reflection plates of the plurality of normal sub pixels adjacent to the defective sub pixel.

In one or more embodiments, the first electrode of the light emitting diode of the defective sub pixel may be electrically connected to the driving transistors of the plurality of normal sub pixels.

In one or more embodiments, the display device may further include a first connection pattern which is connected at one edge of the reflection plate of each of the plurality of sub pixels, and a second connection pattern which is connected at the other edge of the reflection plate of each of the plurality of sub pixels.

In one or more embodiments, the first connection pattern and the second connection pattern which are connected to different reflection plates among the reflection plates may overlap at a boundary between the plurality of sub pixels to form a welding area.

In one or more embodiments, the first connection pattern may include a 1-1-th connection pattern disposed on the first substrate, and a 1-2-th connection pattern which may be disposed on the 1-1-th connection pattern and/or may have a thickness larger than that of the 1-1-th connection pattern.

In one or more embodiments, the second connection pattern may include a 2-1-th connection pattern disposed between the first substrate and the first connection pattern, a 2-2-th connection pattern disposed between the 2-1-th connection pattern and the first connection pattern, and a 2-3-th connection pattern which may be disposed on the 2-2-th connection pattern and/or may have a thickness larger than that of the 2-2-th connection pattern.

In one or more embodiments, the 1-2-th connection pattern and the 2-3-th connection pattern may be connected to the reflection plate.

In one or more embodiments, the 1-1-th connection pattern, the 2-1-th connection pattern, and the 2-2-th connection pattern may overlap the welding area and the 1-2-th connection pattern and the 2-3-th connection pattern may be disposed to be spaced apart from the welding area.

In one or more embodiments, the first connection pattern and the second connection pattern may be disposed to be spaced apart from each other with an insulating layer therebetween at the boundary of the one pair of adjacent normal sub pixels.

In one or more embodiments, , the 1-1-th connection pattern may be in contact with the 2-2-th connection pattern in the welding area disposed at the boundary of the defective sub pixel and the normal sub pixel.

In one or more embodiments, the 1-2-th connection pattern may be disposed in an inner area of the 1-1-th connection pattern, an inner area of the 2-1-th connection pattern.

In one or more embodiments, an inner area of the 2-2-th connection pattern and the 2-2-th connection pattern may be disposed in an inner area of the 2-1-th connection pattern and the 2-3-th connection pattern may be disposed in an inner area of the 2-2-th connection pattern.

In one or more embodiments, an entire edge of the 1-2-th connection pattern may overlap the 1-1-th connection pattern.

In one or more embodiments, an entire edge of the 2-2-th connection pattern may overlap the 2-1-th connection pattern.

In one or more embodiments, an entire edge of the 2-3-th connection pattern may overlap the 2-2-th connection pattern.

In one or more embodiments, the reflection plate may further include a protrusion which protrudes from each of one edge and the other edge to be connected to the first connection pattern and the second connection pattern and the protrusion may include a cutting area which does not overlap the first connection pattern and the second connection pattern.

In one or more embodiments, at least some of the protrusions of the plurality of sub pixels may be cut from the cutting area to be separated from the reflection plate.

In one or more embodiments, the display device may further include a plurality of gate driving areas disposed between the plurality of sub pixels, and a gate driver which may be disposed in the plurality of gate driving areas and may include a plurality of gate driving transistors.

In one or more embodiments, the plurality of transistors of the plurality of sub pixels may include an active layer which is formed of any one of oxide semiconductor, amorphous silicon, and polysilicon.

In one or more embodiments, the plurality of gate driving transistors of the gate driver may include an active layer which is formed of any one of oxide semiconductor, amorphous silicon, and polysilicon.

In one or more embodiments, the active layers of the plurality of gate driving transistors of the gate driver may be formed of different materials.

Other detailed matters of the exemplary embodiments are included in the detailed description and the drawings.

According to the present disclosure, a defective sub pixel is darkened only by two welding processes and a repair process may be performed.

According to the present disclosure, a defective sub pixel may be simply re-darkened by one cutting process.

According to the present disclosure, a welding process is performed on a capacitor connected to a driving transistor to darken a defective pixel circuit.

According to the present disclosure, a light emitting diode of a defective sub pixel may be easily connected to a pixel circuit of a normal sub pixel using a reflection plate.

According to the present disclosure, an intensity of laser which is irradiated during the repair is reduced to minimize the damage of the periphery of the area in which the laser is irradiated.

According to the present disclosure, a short failure generated in a first connection pattern and a second connection pattern for connecting the reflection plate due to the static electricity may be reduced.

According to the present disclosure, the repair process is performed using a reflection plate and a capacitor without a separate structure only for a repair process so that a structure of the display device may be simplified.

The effects according to the present disclosure are not limited to the contents exemplified above, and more various effects are included in the present specification.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a schematic diagram of a display device according to an exemplary embodiment of the present disclosure;
FIG. 2A is a partial cross-sectional view of a display device according to an exemplary embodiment of the present disclosure;
FIG. 2B is a perspective view of a tiling display device according to an exemplary embodiment of the present disclosure;
FIG. 3 is a plan view of a display panel of a display device according to an exemplary embodiment of the present disclosure;
FIG. 4 is a circuit diagram of a sub pixel of a display device according to an exemplary embodiment of the present disclosure;
FIG. 5 is a plan view of a sub pixel of a display device according to an exemplary embodiment of the present disclosure;
FIG. 6 is a plan view of a pixel area of a display device according to an exemplary embodiment of the present disclosure;
FIG. 7 is a cross-sectional view of a display device according to an exemplary embodiment of the present disclosure;
FIG. 8 is a circuit diagram for explaining a repair process of a sub pixel according to an exemplary embodiment of the present disclosure;
FIGS. 9A and 9B are cross-sectional views of a second capacitor of a display device according to an exemplary embodiment of the present disclosure;
FIG. 10 is an enlarged plan view of a display device according to an exemplary embodiment of the present disclosure; and
FIGS. 11A and 11B are cross-sectional views taken along the line XI-XI' of FIG. 10.

### DETAILED DESCRIPTION OF THE EMBODIMENT

Advantages and characteristics of the present disclosure and a method of achieving the advantages and characteristics will be clear by referring to exemplary embodiments described below in detail together with the accompanying drawings. , The exemplary embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other

Hereinafter, a display device according to exemplary embodiments of the present disclosure will be described in detail with reference to accompanying drawings.

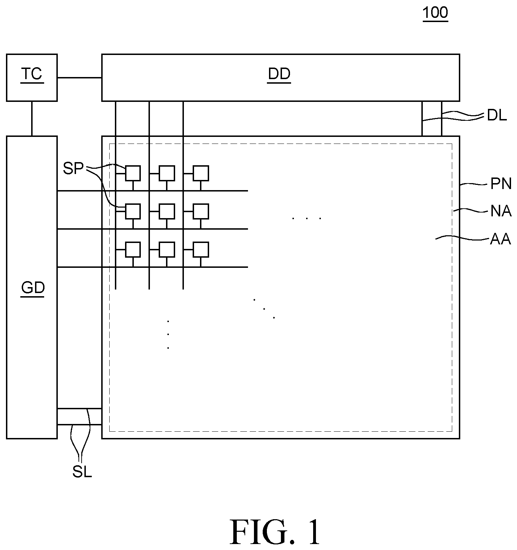

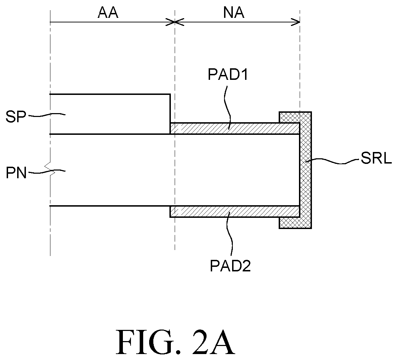

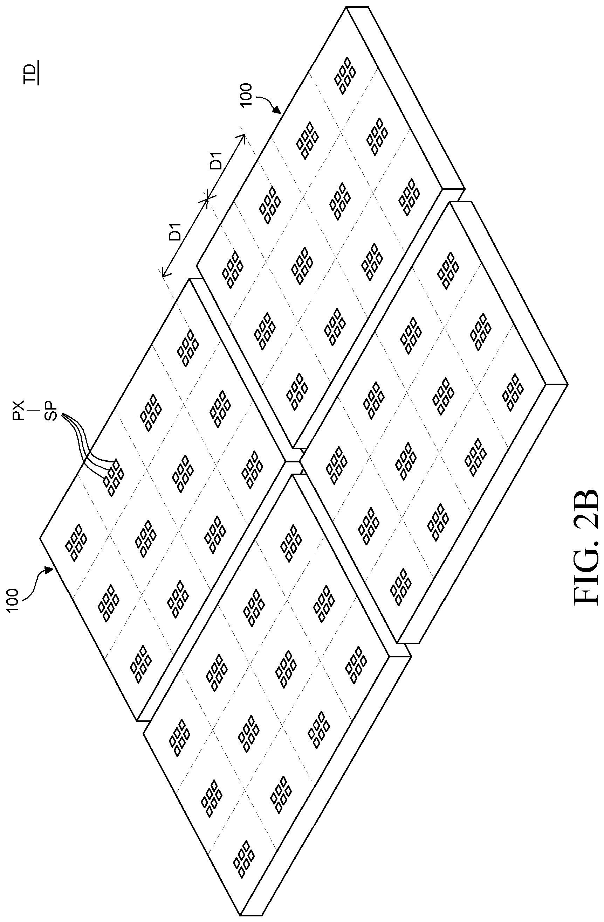

FIG. 1 is a schematic diagram of a display device according to an exemplary embodiment of the present disclosure. FIG. 2A is a partial cross-sectional view of a display device according to an exemplary embodiment of the present disclosure. FIG. 2B is a perspective view of a tiling display device according to an exemplary embodiment of the present disclosure. In FIG. 1, for the convenience of description, among various components of the display device 100, only a display panel PN, a gate driver GD, a data driver DD, and a timing controller TC are illustrated.

Referring to FIG. 1, the display device 100 includes a display panel PN including a plurality of sub pixels SP, a gate driver GD and a data driver DD which supply various signals to the display panel PN, and a timing controller TC which controls the gate driver GD and the data driver DD.

The gate driver GD supplies a plurality of scan signals to a plurality of scan lines SL in accordance with a plurality of gate control signals supplied from the timing controller TC. Even though in FIG. 1, it is illustrated that one gate driver GD is disposed to be spaced apart from one side of the display panel PN, the number of the gate drivers GD and the placement thereof are not limited thereto.

The data driver DD converts image data input from the timing controller TC into a data voltage using a reference gamma voltage in accordance with a plurality of data control signals supplied from the timing controller TC. The data driver DD may supply the converted data voltage to the plurality of data lines DL.

The timing controller TC aligns image data input from the outside to supply the image data to the data driver DD. The timing controller TC may generate a gate control signal and a data control signal using synchronization signals input from the outside, such as a dot clock signal, a data enable signal, and horizontal/vertical synchronization signals. The timing controller TC may supply the generated gate control signal and data control signal to the gate driver GD and the data driver DD, respectively, to control the gate driver GD and the data driver DD.

The display panel PN is a configuration which displays images to the user and includes the plurality of sub pixels SP. In the display panel PN, the plurality of scan lines SL and the plurality of data lines DL intersect each other and the plurality of sub pixels SP is connected to the scan lines SL and the data lines DL, respectively. In addition, even though it is not illustrated in the drawing, each of the plurality of sub pixels SP may be connected to a high potential power line VL1, a low potential power line VL2, a reference line RL, and the like.

In the display panel PN, an active area AA and the non-active area NA enclosing the active area AA may be defined.

The active area AA is an area in which images are displayed in the display device 100. In the active area AA, a plurality of sub pixels SP which configures a plurality of pixels PX and a circuit for driving the plurality of sub pixels SP may be disposed. The plurality of sub pixels SP is a minimum unit which configures the active area AA and n sub pixels SP may form one pixel PX. In each of the plurality of sub pixels SP, a light emitting diode 130, a thin film transistor for driving the light emitting diode 130, and the like may be disposed. The plurality of light emitting diodes 130 may be defined in different ways depending on the type of the display panel PN. For example, when the display panel PN is an inorganic light emitting display panel PN, the light emitting diode 130 may be a light emitting diode (LED) or a micro light emitting diode (LED).

In the active area AA, a plurality of wiring lines which transmits various signals to the plurality of sub pixels SP is disposed. For example, the plurality of wiring lines may include a plurality of data lines DL which supplies a data voltage to each of the plurality of sub pixels SP, a plurality of scan lines SL which supplies a scan signal to each of the plurality of sub pixels SP, and the like. The plurality of scan lines SL extends in one direction in the active area AA to be connected to the plurality of sub pixels SP and the plurality of data lines DL extends in a direction different from the one direction in the active area AA to be connected to the plurality of sub pixels SP. In addition, in the active area AA, a low potential power line VL2, a high potential power line VL1, and the like may be further disposed, but are not limited thereto.

The non-active area NA is an area where images are not displayed so that the non-active area NA may be defined as an area extending from the active area AA. In the non-active area NA, a link line which transmits a signal to the sub pixel SP of the active area AA, a pad electrode, or a driving IC, such as a gate driver IC or a data driver IC, may be disposed.

In the meantime, the non-active area NA may be located on a rear surface of the display panel PN, that is, a surface on which the sub pixels SP are not disposed or may be omitted, and is not limited as illustrated in the drawing.

In the meantime, a driver, such as a gate driver GD, a data driver DD, and a timing controller TC, may be connected to the display panel PN in various ways. For example, the gate driver GD may be mounted in the non-active area NA in a gate in panel (GIP) manner or mounted between the plurality of sub pixels SP in the active area AA in a gate in active area (GIA) manner. For example, the data driver DD and the timing controller TC are formed in separate flexible film and printed circuit board. The data driver DD and the timing controller TC may be electrically connected to the display panel PN by bonding the flexible film and the printed circuit board to the pad electrode formed in the non-active area NA of the display panel PN.

If the gate driver GD is mounted in the GIP manner and the data driver DD and the timing controller TC transmit a signal to the display panel PN through a pad electrode of the non-active area NA, an area of the non-active area NA for disposing the gate driver GD and the pad electrode is necessary more than a predetermined level. Accordingly, a bezel may be increased.

In contrast, when the gate driver GD is mounted in the active area AA in the GIA manner and a side line SRL which connects the signal line on the front surface of the display panel PN to the pad electrode on a rear surface of the display panel PN is formed to bond the flexible film and the printed circuit board onto a rear surface of the display panel PN, the non-active area NA may be minimized on the front surface of the display panel PN. That is, when the gate driver GD, the data driver DD, and the timing controller TC are connected to the display panel PN as described above, a zero bezel with substantially no bezel may be implemented.

Specifically, referring to FIGS. 2A and 2B, in the non-active area NA of the display panel PN, a plurality of pad electrodes for transmitting various signals to the plurality of sub pixels SP is disposed. For example, in the non-active area NA on the front surface of the display panel PN, a first pad electrode PAD1 which transmits a signal to the plurality of sub pixels SP is disposed. In the non-active area NA on the rear surface of the display panel PN, a second pad electrode PAD2 which is electrically connected to a driving component, such as a flexible film and the printed circuit board, is disposed. That is, on the front surface of the display panel PN on which images are displayed, only a pad area of the non-active area NA in which the first pad electrode PAD1 is disposed may be formed at minimum.

In this case, even though it is not illustrated in the drawing, various signal lines connected to the plurality of sub pixels SP, for example, a scan line SL or a data line DL extends from the active area AA to the non-active area NA to be electrically connected to the first pad electrode PAD1.

The side line SRL is disposed along a side surface of the display panel PN. The side line SRL may electrically connect a first pad electrode PAD1 on the front surface of the display panel PN and a second pad electrode PAD2 on the rear surface of the display panel PN. Therefore, a signal from a driving component on the rear surface of the display panel PN may be transmitted to the plurality of sub pixels SP through the second pad electrode PAD2, the side line SRL, and the first pad electrode PAD1. Accordingly, a signal transmitting path from the front surface of the display panel PN to the side surface and the rear surface is formed to minimize an area of the non-active area NA on the front surface of the display panel PN.

Referring to FIG. 2B, a tiling display device TD having a large screen size may be implemented by connecting a plurality of display devices 100. At this time, as illustrated in FIG. 2A, when the tiling display device TD is implemented using a display device 100 with a minimized bezel, a seam area in which an image between the display devices 100 is not displayed is minimized so that a display quality may be improved.

For example, the plurality of sub pixels SP may form one pixel PX and a distance D1 between an outermost pixel PX of one display device 100 and an outermost pixel PX of another display device 100 adjacent to one display device may be implemented to be equal to a distance D1 between pixels PX in one display device 100. Accordingly, a distance D1 between pixels PX between the display devices 100 is constantly configured to minimize the seam area.

However, FIGS. 2A and 2B are illustrative so that the display device 100 according to the exemplary embodiment of the present disclosure may be a general display device 100 with a bezel, but is not limited thereto.

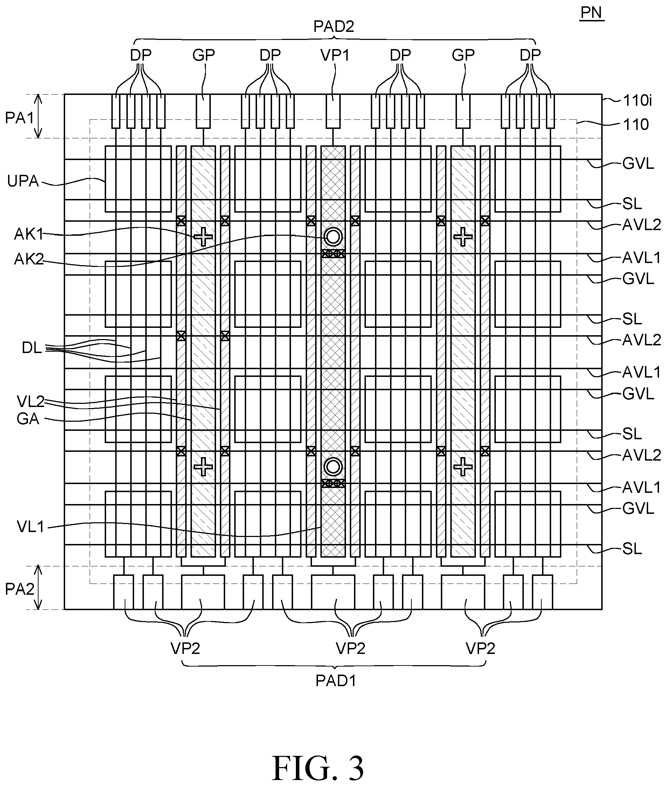

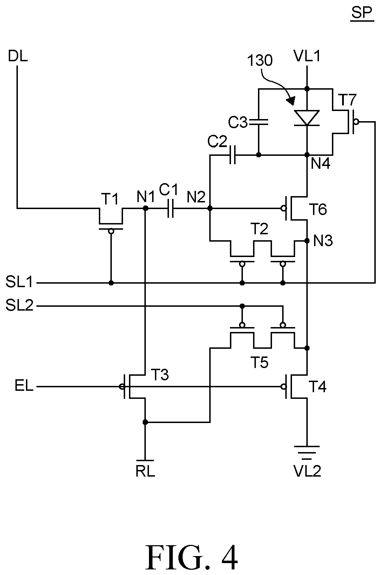

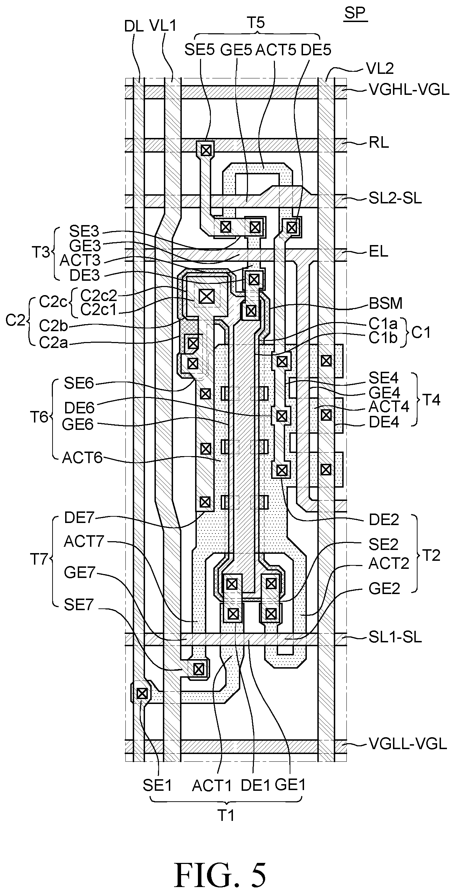

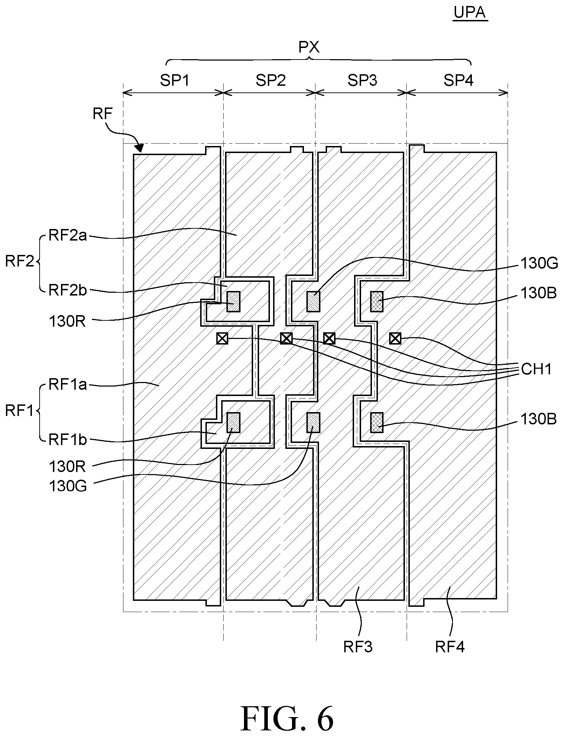

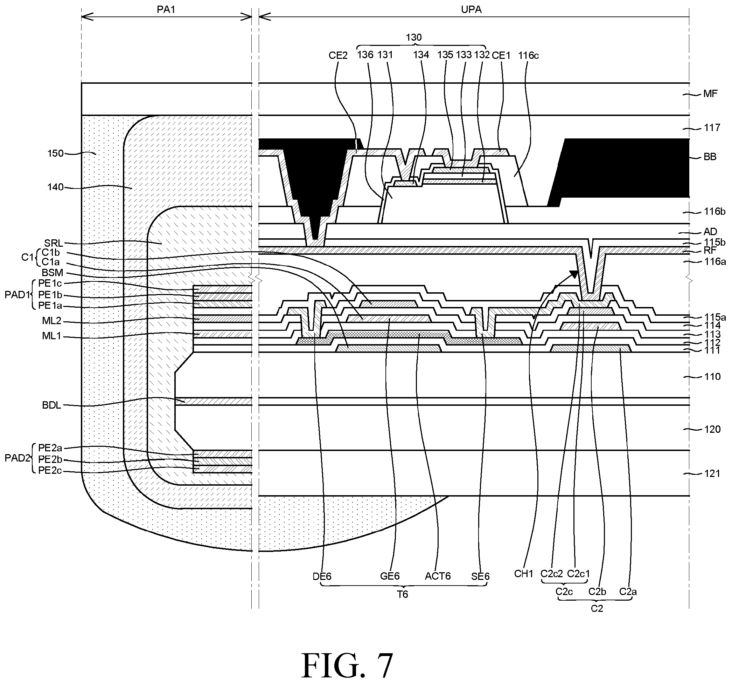

FIG. 3 is a plan view of a display panel of a display device according to an exemplary embodiment of the present disclosure. FIG. 4 is a circuit diagram of a sub pixel of a display device according to an exemplary embodiment of the present disclosure. FIG. 5 is a plan view of a sub pixel of a display device according to an exemplary embodiment of the present disclosure. FIG. 6 is a plan view of a pixel area of a display device according to an exemplary embodiment of the present disclosure. FIG. 7 is a cross-sectional view of a display device according to an exemplary embodiment of the present disclosure. In FIG. 5, for the convenience of description, only a plan view of one sub pixel SP is illustrated.

First, referring to FIG. 3, the display panel PN includes a first substrate 110. The first substrate 110 is a substrate which supports components disposed in the display device 100 and may be an insulating substrate. A plurality of pixels PX is formed on the first substrate 110 to display images. For example, the first substrate 110 may be formed of glass or resin. Further, the first substrate 110 may include polymer or plastic. In some exemplary embodiments, the first substrate 110 may be formed of a plastic material having flexibility.

In the first substrate 110, a plurality of pixel areas UPA, a plurality of gate driving areas GA, and a plurality of pad areas are disposed. Among them, the plurality of pixel areas UPA and the plurality of gate driving areas GA may be included in the active area AA of the display panel PN.

First, the plurality of pixel areas UPA is areas in which the plurality of pixels PX is disposed. The plurality of pixel areas UPA may be disposed by forming a plurality of rows and a plurality of columns. Each of the plurality of pixels PX disposed in the plurality of pixel areas UPA includes a plurality of sub pixels SP. Each of the plurality of sub pixels SP includes a light emitting diode 130 and a pixel circuit to independently emit light.

The plurality of gate driving areas GA is areas where gate drivers GD are disposed. The gate driver GD may be mounted in the active area AA in a gate in active area (GIA) manner. For example, the gate driving area GA may be formed along a row direction and/or column direction between the plurality of pixel areas UPA. The gate driver GD formed in the gate driving area GA may supply the scan signal to the plurality of scan lines SL.

The plurality of pad areas is areas in which a plurality of first pad electrodes PAD1 is disposed. The plurality of first pad electrodes PAD1 may transmit various signals to various wiring lines extending in a column direction in the active area AA. For example, the plurality of first pad electrodes PAD1 includes a data pad DP, a gate pad GP, a high potential power pad VP1, and a low potential power pad VP2. The data pad DP transmits a data voltage to the data line DL and the gate pad GP transmits a clock signal, a start signal, a gate low voltage, a gate high voltage, and the like for driving the gate driver GD to the gate driver GD. The high potential power pad VP1 transmits a high potential power voltage to the high potential power line VL1 and the low potential power pad VP2 transmits a low potential power voltage to the low potential power line VL2.

The plurality of pad areas includes a first pad area PA1 adjacent to an upper edge of the display panel PN and a second pad area PA2 adjacent to a lower edge of the display panel PN. At this time, in the first pad area PA1 and the second pad area PA2, different types of first pad electrodes PAD1 may be disposed. For example, in the first pad area PA1, among the plurality of first pad electrodes PAD1, the data pad DP, the gate pad GP, and the high potential power pad VP1 may be disposed and in the second pad area PA2, the low potential power pad VP2 may be disposed.

At this time, the plurality of first pad electrodes PAD1 may be formed to have different sizes, respectively. For example, the plurality of data pads DP which is connected to the plurality of data lines DL one to one may have a narrower width and the high potential power pad VP1, the low potential power pad VP2, and the gate pad GP may have a larger width. However, widths of the data pad DP, the gate pad GP, the high potential power pad VP1, and the low potential power pad VP2 illustrated in FIG. 3 are illustrative so that the first pad electrode PAD1 may be configured in various sizes, but is not limited thereto.

In the meantime, in order to reduce the bezel of the display panel PN, an edge of the display panel PN may be cut to be removed. The plurality of pixels PX, the plurality of wiring lines, and the plurality of first pad electrodes PAD1 are formed on an initial first substrate 110i and an edge part of the initial first substrate 110i is cut and ground to reduce the bezel area. During the grinding process, a part of the initial first substrate 110i is removed to form a first substrate 110 with a smaller size. At this time, parts of the plurality of first pad electrodes PAD1 and wiring lines disposed at the edge of the first substrate 110 may be removed. Accordingly, only a part of the plurality of first pad electrodes PAD1 may remain on the first substrate 110.

Next, the plurality of data lines DL which extends in a column direction from the plurality of first pad electrodes PAD1 is disposed on the first substrate 110 of the display panel PN. The plurality of data lines DL may extend from the plurality of data pads DP of the first pad area PA1 toward the plurality of pixel areas UPA. The plurality of data lines DL may extend in a column direction and overlap the plurality of pixel areas UPA. Therefore, the plurality of data lines DL may transmit the data voltage to the pixel circuit of each of the plurality of sub pixels SP.

The plurality of high potential power lines VL1 extending in the column direction is disposed on the first substrate 110 of the display panel PN. Some of the plurality of high potential power lines VL1 extend from the high potential power pad VP1 of the first pad area PA1 to the plurality of pixel areas UPA to transmit the high potential power voltage to the light emitting diodes 130 of the plurality of sub pixels SP. The others of the plurality of high potential power lines VL1 may be electrically connected to the other high potential power line VL1 by means of an auxiliary high potential power line AVL1 to be described below. In FIG. 3, for the convenience of description, even though it is illustrated that one high potential power line VL1 and one high potential power pad VP1 are disposed, a plurality of high potential power lines VL1 and high potential power pads VP1 may be disposed.

The plurality of low potential power lines VL2 extending in the column direction is disposed on the first substrate 110 of the display panel PN. At least some of the plurality of low potential power lines VL2 extend from the low potential power pad VP2 of the second pad area PA2 to the plurality of pixel areas UPA to transmit the low potential power voltage to the pixel circuit of each of the plurality of sub pixels SP. The others of the plurality of low potential power lines VL2 may be electrically connected to the other low potential power line VL2 by means of an auxiliary low potential power line AVL2 to be described below.

The plurality of scan lines SL extending in the row direction is disposed on the first substrate 110 of the display panel PN. The plurality of scan lines SL extends in the row direction and may be disposed across the plurality of pixel areas UPA and the plurality of gate driving areas GA. The plurality of scan lines SL may transmit the scan signal from the gate driver GD to the pixel circuits of the plurality of sub pixels SP.

A plurality of auxiliary high potential power lines AVL1 extending in the row direction is disposed on the first substrate 110 of the display panel PN. The plurality of auxiliary high potential power lines AVL1 may be disposed in an area between the plurality of pixel areas UPA. The plurality of auxiliary high potential power lines AVL1 extending in the row direction may be electrically connected to the plurality of high potential power lines VL1 extending in the column direction through a contact hole and form a mesh structure. Therefore, the plurality of auxiliary high potential power lines AVL1 and the plurality of high potential power lines VL1 are configured to form a mesh structure to reduce voltage drop and voltage deviation.

A plurality of auxiliary low potential power lines AVL2 extending in the row direction is disposed on the first substrate 110 of the display panel PN. The plurality of auxiliary low potential power lines AVL2 may be disposed in an area between the plurality of pixel areas UPA. The plurality of auxiliary low potential power lines AVL2 extending in the row direction is electrically connected to the plurality of low potential power lines VL2 extending in the column direction through a contact hole to form a mesh structure. Therefore, the plurality of auxiliary low potential power lines AVL2 and the plurality of low potential power lines VL2 are configured to form a mesh structure to reduce a resistance of the wiring line and reduce voltage deviation.

Referring to FIGS. 3 and 5, the plurality of gate driving lines GVL extending in the row direction and the column direction is disposed on the first substrate 110 of the display panel PN. Some of the plurality of gate driving lines GVL extend from the gate pad GP of the first pad area PA1 to the gate driving area GA to transmit a signal to the gate driver GD. The others of the plurality of gate driving lines GVL extend in the row direction and may transmit the signal to the gate drivers GD of the plurality of gate driving areas GA. Therefore, various signals are transmitted from the gate driving line GVL to the gate driver GD to drive the gate driver GD.

The plurality of gate driving lines GVL may include wiring lines which transmit a clock signal, a start signal, a gate high voltage, and a gate low voltage to the gate driver GD. Therefore, various signals are transmitted from the gate driving line GVL to the gate driver GD to drive the gate driver GD.

For example, referring to FIG. 5, the plurality of gate driving lines GVL may include a gate power line which transmits a power voltage to the gate driver GD of the gate driving area GA. The plurality of gate power lines includes a first gate power line VGHL which transmits a gate high voltage to the gate driver GD and a second gate power line VGLL which transmits a gate low voltage to the gate driver GD.

Referring to FIG. 3, a plurality of alignment keys is disposed in an area between the plurality of pixel areas UPA in the display panel PN. The plurality of alignment keys is used for alignment during the manufacturing process of the display panel PN. The plurality of alignment keys includes a first alignment key AK1 and a second alignment key AK2.

The first alignment key AK1 may be disposed in the gate driving area GA between the plurality of pixel areas UPA. The first alignment key AK1 may be used to inspect an alignment position of the plurality of light emitting diodes 130. For example, the first alignment key AK1 may have a cross shape, but is not limited thereto.

The second alignment key AK2 may be disposed to overlap the high potential power line VL1 between the plurality of pixel areas UPA. In the high potential power line VL1, a hole overlapping the second alignment key AK2 is formed to divide the second alignment key AK2 and the high potential power line VL1. The second alignment key AK2 may be used to align the display panel PN and a donor. The display panel PN and the donor are aligned using the second alignment key AK2 and the plurality of light emitting diodes 130 of the donor may be transferred onto the display panel PN. For example, the second alignment key AK2 may have a circular ring shape, but is not limited thereto.

Hereinafter, the plurality of sub pixels SP of the pixel area UPA will be described in more detail with reference to FIGS. 4 to 7.

Referring to FIG. 6, in one pixel area UPA, a plurality of sub pixels SP which forms one pixel PX is disposed. For example, the plurality of sub pixels SP may include a first sub pixel SP1, a second sub pixel SP2, a third sub pixel SP3, and a fourth sub pixel SP4 which emit different color light. For example, the first sub pixel SP1 and the second sub pixel SP2 may be red sub pixels, the third sub pixel SP3 may be a green sub pixel, and the fourth sub pixel SP4 may be a blue sub pixel, but it is not limited thereto.

Hereinafter, the description will be made by assuming that one pixel PX includes one first sub pixel SP1, one second sub pixel SP2, one third sub pixel SP3, and one fourth sub pixel SP4, that is, two red sub pixels, one green sub pixel, and one blue sub pixel. However, the configuration of the pixel PX is not limited thereto.

Referring to FIGS. 4 and 5, each of the plurality of sub pixels SP is connected to a first scan line SL1, a second scan line SL2, a data line DL, an emission control signal line EL, a reference line RL, a high potential power line VL1, and a low potential power line VL2. In each of the plurality of sub pixels SP, a pixel circuit including a first transistor T1, a second transistor T2, a third transistor T3, a fourth transistor T4, a fifth transistor T5, a sixth transistor T6, a seventh transistor T7, a first capacitor C1, a second capacitor C2, and a third capacitor C3 and a light emitting diode 130 connected to the pixel circuit are disposed.

First, the first transistor T1, the second transistor T2, the third transistor T3, the fourth transistor T4, the fifth transistor T5, the sixth transistor T6, and the seventh transistor T7 of the pixel circuit are disposed in each of the plurality of sub pixels SP. Each of the first transistor T1, the second transistor T2, the third transistor T3, the fourth transistor T4, the fifth transistor T5, the sixth transistor T6, and the seventh transistor T7 includes a gate electrode, a source electrode, and a drain electrode.

The first transistor T1, the second transistor T2, the third transistor T3, the fourth transistor T4, the fifth transistor T5, the sixth transistor T6, and the seventh transistor T7 may be N-type transistors or P-type transistors. In the N-type transistor, carriers are electrons so that electrons may flow from the source electrode to the drain electrode and currents may flow from the drain electrode to the source electrode. In the P-type transistor, carriers are holes so that holes may flow from the source electrode to the drain electrode and currents may flow from the source electrode to the drain electrode. For example, one of the plurality of transistors may be an N-type transistor and the other one of the plurality of transistors may be a P-type transistor. Hereinafter, the description will be made by assuming that the plurality of transistors of the sub pixel SP is P-type transistors, but the present disclosure is not limited thereto.

The first transistor T1 includes a first gate electrode GE1, a first source electrode SE1, and a first drain electrode DE1. The first gate electrode GE1 is connected to a first scan line SL1, the first source electrode SE1 is connected to a data line DL, and the first drain electrode DE1 is connected to a first node N1. The first transistor T1 may transmit a data voltage from the data line DL to the first node N1 based on a scan signal of the first scan line SL1.

The second transistor T2 includes a second gate electrode GE2, a second source electrode SE2, and a second drain electrode DE2. The second gate electrode GE2 is connected to the first scan line SL1, the second source electrode SE2 is connected to a second node N2, and the second drain electrode DE2 is connected to a third node N3. The second transistor T2 may short a sixth gate electrode GE6 and a sixth drain electrode DE6 of the sixth transistor T6 and the sixth transistor T6 may be diode-connected. In the diode connection, the gate electrode and the drain electrode are shorted so that the transistor operates as a diode. At this time, the second transistor T2 forms a dual-gate structure having a low off-current to reduce the current leakage from the sixth gate electrode GE6 of the sixth transistor T6. Further, the second transistor T2 may be implemented by an oxide semiconductor transistor having a low off-current, but is not limited thereto.

The third transistor T3 includes a third gate electrode GE3, a third source electrode SE3, and a third drain electrode DE3. The third gate electrode GE3 is connected to the emission control signal line EL, the third source electrode SE3 is connected to the reference line RL, and the third drain electrode DE3 is connected to the first node N1. The third transistor T3 may transmit a reference voltage from the reference line RL to the first node N1 based on the emission control signal of the emission control signal line EL and maintain a constant voltage of the second node N2 while the light emitting diode 130 emits light.

The fourth transistor T4 includes a fourth gate electrode GE4, a fourth source electrode SE4, and a fourth drain electrode DE4. The fourth gate electrode GE4 is connected to the emission control signal line EL, the fourth source electrode SE4 is connected to the third node N3, and the fourth drain electrode DE4 is connected to the low potential power line VL2. The fourth transistor T4 may supply a low potential power voltage to the third node N3 based on the emission control signal to flow a driving current.

The fifth transistor T5 includes a fifth gate electrode GE5, a fifth source electrode SE5, and a fifth drain electrode DE5. The fifth gate electrode GE5 is connected to a second scan line SL2, the fifth source electrode SE5 is connected to the reference line RL, and the fifth drain electrode DE5 is connected to the third node N3. The fifth transistor T5 may supply the reference voltage to the third node N3 based on a scan signal of the second scan line SL2 and reset a sixth drain electrode DE6 of the sixth transistor T6 which is the third node N3 with the reference voltage. At this time, even though in the drawing, it is illustrated that the fifth transistor T5 has a dual gate structure, the fifth transistor T5 may also be formed with a single gate structure, but is not limited thereto.

The sixth transistor T6 includes a sixth gate electrode GE6, a sixth source electrode SE6, and the sixth drain electrode DE6. The sixth gate electrode GE6 is connected to the second node N2, the sixth source electrode SE6 is connected to the fourth node N4, and the sixth drain electrode DE6 is connected to the third node N3. The sixth transistor T6 is turned on to control a driving current which flows in the light emitting diode 130 and may be also referred to as a driving transistor.

The seventh transistor T7 includes a seventh gate electrode GE7, a seventh source electrode SE7, and a seventh drain electrode DE7. The seventh gate electrode GE7 is connected to the first scan line SL1, the seventh source electrode SE7 is connected to the high potential power line VL1, and the seventh drain electrode DE7 is connected to a fourth node N4. The seventh source electrode SE7 may transmit the high potential power voltage to the fourth node N4 based on the scan signal of the first scan line SL1 and suppress the emission of the light emitting diode 130 while supplying the data voltage.

The first capacitor C1 includes a plurality of capacitor electrodes connected to the first node N1 and the second node N2. The first capacitor C1 may adjust a voltage of the second node N2 using a coupling characteristic and fixes a voltage applied to the sixth gate electrode GE6 of the sixth transistor T6 while the light emitting diode 130 emits light to maintain a constant driving current.

The second capacitor C2 includes a plurality of capacitor electrodes connected to the second node N2 and the fourth node N4. In other words, the second capacitor C2 may be connected between the sixth gate electrode GE6 and the sixth source electrode SE6 of the sixth transistor T6. The second capacitor C2 may be connected between the sixth gate electrode GE6 and the first electrode 134 of the light emitting diode 130 which is a cathode.

When a voltage fluctuates in the first node N1, a voltage of the second node N2 may also fluctuate. At this time, the second capacitor C2 which is connected to the first capacitor C1 in series may be coupled to the first capacitor C1 and a voltage of the first node N1 may be transmitted to the voltage of the second node N2 according to a capacitance ratio of the first capacitor C1 and the second capacitor C2. Accordingly, a transfer rate of a data voltage from the first node N1 to the second node N2 may be lowered using the second capacitor C2. Further, when the light emitting diode 130 is configured as a micro LED having a large slope of the I-V curve, the transfer rate of the data voltage is lowered using the second capacitor C2 to display more subtle gray scales.

The third capacitor C3 is a capacitor formed between the fourth node N4 and the high potential power line VL1 and may be a sort of parasitic capacitor. That is, the third capacitor C3 may be a capacitor formed between existing configurations without additionally forming a separate electrode. The third capacitor C3 increases an intrinsic capacitance in the light emitting diode 130 to emit light with higher luminance from the light emitting diode 130.

The third capacitor C3 may be formed between the high potential power line VL1, a configuration which is electrically connected to the high potential power line VL1, and a configuration which is electrically connected to the fourth node N4. For example, the fourth node N4 may be electrically connected to the first electrode 134 of the light emitting diode 130, the sixth source electrode SE6 of the sixth transistor T6, a light shielding layer BSM, some reflection plates RF, a second connection electrode CE to be described below, and the like. The high potential power line VL1 may be electrically connected to some reflection plates RF, a first connection electrode CE1 to be described below, and the like. In the sub pixel SP, areas of the configurations electrically connected to the fourth node N4 and areas of the configurations electrically connected to the high potential power line VL1 are relatively large so that the third capacitor C3 may be formed therebetween.

Next, referring to FIGS. 5 and 7 together, the light shielding layer BSM is disposed on the first substrate 110. The light shielding layer BSM blocks light which is incident onto a sixth active layer ACT6 of the sixth transistor T6 which is a driving transistor to reduce a leakage current. For example, the light shielding layer BSM is disposed below the sixth active layer ACT6 of the sixth transistor T6 to block light which is incident onto the sixth active layer ACT6. If light is irradiated onto the sixth active layer ACT6, a leakage current is generated, which deteriorates the reliability of the transistor. Accordingly, the light shielding layer BSM which blocks the light is disposed on the first substrate 110 to improve the reliability of the sixth transistor T6. The light shielding layer BSM may be configured by an opaque conductive material such as copper (Cu), aluminum (Al), molybdenum (Mo), nickel (Ni), titanium (Ti), chrome (Cr), or an alloy thereof, but is not limited thereto.

A buffer layer 111 is disposed on the light shielding layer BSM. The buffer layer 111 may reduce permeation of moisture or impurities through the first substrate 110. The buffer layer 111 may be configured by a single layer or a double layer of silicon oxide SiOx or silicon nitride SiNx, but is not limited thereto. However, the buffer layer 111 may be omitted depending on a type of the first substrate 110 or a type of the thin film transistor, but is not limited thereto.

The first transistor TR1 including a first active layer ACT1, a first gate electrode GE1, a first source electrode SE1, and a first drain electrode DE1 is disposed in each of the plurality of sub pixels SP on the buffer layer 111.

First, the first active layer ACT1 of the first transistor T1 is disposed on the buffer layer 111. The first active layer ACT1 may be formed of a semiconductor material such as an oxide semiconductor, amorphous silicon, or polysilicon, but is not limited thereto.

The gate insulating layer 112 is disposed on the first active layer ACT1. The gate insulating layer 112 is an insulating layer which electrically insulates the first active layer ACT1 from the first gate electrode GE1 and may be configured by a single layer or a double layer of silicon oxide SiOx or silicon nitride SiNx, but is not limited thereto.

The first gate electrode GE1 is disposed on the gate insulating layer 112. The first gate electrode GE1 is integrally formed with the first scan line SL1 to be electrically connected to the first scan line SL1. The first gate electrode GE1 may be configured by a conductive material, such as copper (Cu), aluminum (Al), molybdenum (Mo), nickel (Ni), titanium (Ti), chrome (Cr), or an alloy thereof, but is not limited thereto.

A first interlayer insulating layer 113 and a second interlayer insulating layer 114 are disposed on the first gate electrode GE1. Contact holes through which the first source electrode SE1 and the first drain electrode DE1 are connected to the first active layer ACT1 may be formed in the first interlayer insulating layer 113 and the second interlayer insulating layer 114, respectively. The first interlayer insulating layer 113 and the second interlayer insulating layer 114 are insulating layers which protect components therebelow and may be configured by single layers or double layers of silicon oxide SiOx or silicon nitride SiNx, but are not limited thereto.

A first source electrode SE1 and a first drain electrode DE1 which are electrically connected to the first active layer ACT1 are disposed on the second interlayer insulating layer 114. The source electrode SE1 is integrally formed with the data line DL to be electrically connected to the data line DL and the first drain electrode DE1 may be electrically connected to a 1-2-th capacitor electrode C1b of the first capacitor C1. The first source electrode SE1 and the first drain electrode DE1 may be configured by a conductive material, such as copper (Cu), aluminum (Al), molybdenum (Mo), nickel (Ni), titanium (Ti), chrome (Cr), or an alloy thereof, but are not limited thereto.

The second transistor T2 which includes a second active layer ACT2, the second gate electrode GE2, the second source electrode SE2, and the second drain electrode DE2 is disposed on the buffer layer 111.

The second active layer ACT2 is disposed on the buffer layer 111. The second active layer ACT2 may be formed of a semiconductor material, such as an oxide semiconductor, amorphous silicon, or polysilicon, but is not limited thereto.

The gate insulating layer 112 is disposed on the second active layer ACT2 and the second gate electrode GE2 is disposed on the gate insulating layer 112. The second gate electrode GE2 is integrally formed with the first scan line SL1 to be electrically connected to the second scan line SL2. The second gate electrode GE2 may be configured by a conductive material, such as copper (Cu), aluminum (Al), molybdenum (Mo), nickel (Ni), titanium (Ti), chrome (Cr), or an alloy thereof, but is not limited thereto.

The first interlayer insulating layer 113 and the second interlayer insulating layer 114 are disposed on the second gate electrode GE2 and the second source electrode SE2 and the second drain electrode DE2 which are electrically connected to the second active layer ACT2 are disposed on the second interlayer insulating layer 114. The second source electrode SE2 is electrically connected to the gate electrode of the sixth transistor T6 which is a 1-1-th capacitor electrode C1a of the first capacitor C1. The second drain electrode DE2 is electrically connected to the fifth drain electrode DE5 of the fifth transistor T5 and the fourth source electrode SE4 of the fourth transistor T4. The second source electrode SE2 and the second drain electrode DE2 may be configured by a conductive material, such as copper (Cu), aluminum (Al), molybdenum (Mo), nickel (Ni), titanium (Ti), chrome (Cr), or an alloy thereof, but are not limited thereto.

The third transistor T3 which includes a third active layer ACT3, the third gate electrode GE3, the third source electrode SE3, and the third drain electrode DE3 is disposed on the buffer layer 111.

The third active layer ACT3 is disposed on the buffer layer 111. The third active layer ACT3 may be formed of a semiconductor material, such as an oxide semiconductor, amorphous silicon, or polysilicon, but is not limited thereto.

The gate insulating layer 112 is disposed on the third active layer ACT3 and the third gate electrode GE3 is disposed on the gate insulating layer 112. The third gate electrode GE3 is integrally formed with the emission control signal line EL to be electrically connected to the emission control signal line EL. The third gate electrode GE3 may be configured by a conductive material, such as copper (Cu), aluminum (Al), molybdenum (Mo), nickel (Ni), titanium (Ti), chrome (Cr), or an alloy thereof, but is not limited thereto.

The first interlayer insulating layer 113 and the second interlayer insulating layer 114 are disposed on the third gate electrode GE3 and the third source electrode SE3 and the third drain electrode DE3 which are electrically connected to the third active layer ACT3 are disposed on the second interlayer insulating layer 114. The third source electrode SE3 is electrically connected to the fifth source electrode SE5 and the reference line RL and the third drain electrode DE3 is electrically connected to the 1-2-th capacitor electrode C1b of the first capacitor C1 and the first drain electrode DE1 of the first transistor T1. The third source electrode SE3 and the third drain electrode DE3 may be configured by a conductive material, such as copper (Cu), aluminum (Al), molybdenum (Mo), nickel (Ni), titanium (Ti), chrome (Cr), or an alloy thereof, but are not limited thereto.

The fourth transistor T4 which includes a fourth active layer ACT4, the fourth gate electrode GE4, the fourth source electrode SE4, and the fourth drain electrode DE4 is disposed on the buffer layer 111.

The fourth active layer ACT4 is disposed on the buffer layer 111. The fourth active layer ACT4 may be formed of a semiconductor material such as an oxide semiconductor, amorphous silicon, or polysilicon, but is not limited thereto.

The gate insulating layer 112 is disposed on the fourth active layer ACT4 and the fourth gate electrode GE4 is disposed on the gate insulating layer 112. The fourth gate electrode GE4 is integrally formed with the emission control signal line EL to be electrically connected to the emission control signal line EL. The fourth gate electrode GE4 may be configured by a conductive material, such as copper (Cu), aluminum (Al), molybdenum (Mo), nickel (Ni), titanium (Ti), chrome (Cr), or an alloy thereof, but is not limited thereto.

The first interlayer insulating layer 113 and the second interlayer insulating layer 114 are disposed on the fourth gate electrode GE4 and the fourth source electrode SE4 and the fourth drain electrode DE4 which are electrically connected to the fourth active layer ACT4 are disposed on the second interlayer insulating layer 114. The fourth source electrode SE4 is electrically connected to the fifth drain electrode DE5 of the fifth transistor T5 and the second drain electrode DE2 and the fourth drain electrode DE4 is electrically connected to the low potential power line VL2. At this time, the low potential power line VL2 and the fourth drain electrode DE4 may be integrally formed on the same layer with the same material. The fourth source electrode SE4 and the fourth drain electrode DE4 may be configured by a conductive material, such as copper (Cu), aluminum (Al), molybdenum (Mo), nickel (Ni), titanium (Ti), chrome (Cr), or an alloy thereof, but are not limited thereto.

The fifth transistor T5 which includes a fifth active layer ACT5, the fifth gate electrode GE5, the fifth source electrode SE5, and the fifth drain electrode DE5 is disposed on the buffer layer 111.

The fifth active layer ACT5 is disposed on the buffer layer 111. The fifth active layer ACT5 may be formed of a semiconductor material such as an oxide semiconductor, amorphous silicon, or polysilicon, but is not limited thereto.

The gate insulating layer 112 is disposed on the fifth active layer ACT5 and the fifth gate electrode GE5 is disposed on the gate insulating layer 112. The fifth gate electrode GE5 is electrically connected to the second scan line SL2. The fifth gate electrode GE5 may be integrally formed with the second scan line SL2 on the same layer with the same material. The fifth gate electrode GE5 may be configured by a conductive material such as copper (Cu), aluminum (Al), molybdenum (Mo), nickel (Ni), titanium (Ti), chrome (Cr), or an alloy thereof, but is not limited thereto.

The first interlayer insulating layer 113 and the second interlayer insulating layer 114 are disposed on the fifth gate electrode GE5 and the fifth source electrode SE5 and the fifth drain electrode DE5 which are electrically connected to the fifth active layer ACT5 are disposed on the second interlayer insulating layer 114. The fifth source electrode SE5 is connected to the reference line RL, the fifth drain electrode DE5 is connected to the sixth drain electrode DE6, the fourth source electrode SE4, and the second drain electrode DE2. The fifth source electrode SE5 and the fifth drain electrode DE5 may be configured by a conductive material, such as copper (Cu), aluminum (Al), molybdenum (Mo), nickel (Ni), titanium (Ti), chrome (Cr), or an alloy thereof, but are not limited thereto.

The sixth transistor T6 which includes a sixth active layer ACT6, the sixth gate electrode GE6, the sixth source electrode SE6, and the sixth drain electrode DE6 is disposed on the buffer layer 111.

The sixth active layer ACT6 is disposed on the buffer layer 111. The sixth active layer ACT6 may be formed of a semiconductor material such as an oxide semiconductor, amorphous silicon, or polysilicon, but is not limited thereto.

The gate insulating layer 112 is disposed on the sixth active layer ACT6 and the sixth gate electrode GE6 is disposed on the gate insulating layer 112. The sixth gate electrode GE6 is electrically connected to the 1-1-th capacitor electrode C1a of the first capacitor C1 and the second source electrode SE2. The sixth gate electrode GE6 may be configured by a conductive material, such as copper (Cu), aluminum (Al), molybdenum (Mo), nickel (Ni), titanium (Ti), chrome (Cr), or an alloy thereof, but is not limited thereto.

The first interlayer insulating layer 113 and the second interlayer insulating layer 114 are disposed on the sixth gate electrode GE6 and the sixth source electrode SE6 and the sixth drain electrode DE6 which are electrically connected to the sixth active layer ACT6 are disposed on the second interlayer insulating layer 114. The sixth source electrode SE6 is electrically connected to a 2-1-th capacitor electrode C2a and a 2-3-th capacitor electrode C2c of the second capacitor C2 and the first electrode 134 of the light emitting diode 130. The sixth drain electrode DE6 is electrically connected to the fifth drain electrode DE5, the fourth source electrode SE4, and the second drain electrode DE2. The sixth source electrode SE6 and the sixth drain electrode DE6 may be configured by a conductive material, such as copper (Cu), aluminum (Al), molybdenum (Mo), nickel (Ni), titanium (Ti), chrome (Cr), or an alloy thereof, but are not limited thereto.

The seventh transistor T7 which includes a seventh active layer ACT7, the seventh gate electrode GE7, the seventh source electrode SE7, and the seventh drain electrode DE7 is disposed on the buffer layer 111.

The seventh active layer ACT7 is disposed on the buffer layer 111. The seventh active layer ACT7 may be formed of a semiconductor material such as an oxide semiconductor, amorphous silicon, or polysilicon, but is not limited thereto.

The gate insulating layer 112 is disposed on the seventh active layer ACT7 and the seventh gate electrode GE7 is disposed on the gate insulating layer 112. The seventh gate electrode GE7 is connected to the first scan line SL1. The seventh gate electrode GE7 may be integrally formed with the first scan lien SL1 to be electrically connected to the first scan line SL1. The seventh gate electrode GE7 may be configured by a conductive material, such as copper (Cu), aluminum (Al), molybdenum (Mo), nickel (Ni), titanium (Ti), chrome (Cr), or an alloy thereof, but is not limited thereto.

The first interlayer insulating layer 113 and the second interlayer insulating layer 114 are disposed on the seventh gate electrode GE7 and the seventh source electrode SE7 and the seventh drain electrode DE7 which are electrically connected to the seventh active layer ACT7 are disposed on the second interlayer insulating layer 114. The seventh source electrode SE7 is electrically connected to the high potential power line VL1 and the seventh drain electrode DE7 is electrically connected to the first electrode 134 of the light emitting diode 130 and the 2-1-th capacitor electrode C2a and the 2-3-th capacitor electrode C2c of the second capacitor C2. The seventh source electrode SE7 and the seventh drain electrode DE7 may be configured by a conductive material, such as copper (Cu), aluminum (Al), molybdenum (Mo), nickel (Ni), titanium (Ti), chrome (Cr), or an alloy thereof, but are not limited thereto.

The first capacitor C1 is disposed on the gate insulating layer 112. The first capacitor C1 includes a 1-1-th capacitor electrode C1a and a 1-2-th capacitor electrode C1b.

First, the 1-1-th capacitor electrode C1a is disposed on the gate insulating layer 112. The 1-1-th capacitor electrode C1a may be integrally formed with the sixth gate electrode GE6 of the sixth transistor T6. Accordingly, the 1-1-th capacitor electrode C1a may be electrically connected to the sixth gate electrode GE6 and the second source electrode SE2.

The 1-2-th capacitor electrode C1b is disposed on the first interlayer insulating layer 113. The 1-2-th capacitor electrode C1b is disposed to overlap the 1-1-th capacitor electrode C1a with the first interlayer insulating layer 113 therebetween. The 1-2-th capacitor electrode C1b may be electrically connected to the first drain electrode DE1 and the third drain electrode DE3.

The second capacitor C2 is disposed on the first substrate 110. The second capacitor C2 includes a 2-1-th capacitor electrode C2a, a 2-2-th capacitor electrode C2b, and a 2-3-th capacitor electrode C2c. The second capacitor C2 includes the 2-1-th capacitor electrode C2a which is a lower capacitor electrode, the 2-2-th capacitor electrode C2b which is an intermediate capacitor electrode, and the 2-3-th capacitor electrode C2c which is an upper capacitor electrode.

The 2-1-th capacitor electrode C2a is disposed on the substrate. The 2-1-th capacitor electrode C2a extends from the light shielding layer BSM and may be integrally formed with the light shielding layer BSM. At this time, the 2-1-th capacitor electrode C2a may be electrically connected to the sixth source electrode SE6 through a contact hole formed in the buffer layer 111 and the gate insulating layer 112. At this time, an intermediate electrode which electrically connects the 2-1-th capacitor electrode C2a and the sixth source electrode SE6 may be disposed between the gate insulating layer 112 and the first interlayer insulating layer 113. However, the 2-1-th capacitor electrode C2a and the sixth source electrode SE6 may be electrically connected without the intermediate electrode, but are not limited thereto.

The 2-2-th capacitor electrode C2b is disposed on the buffer layer 111 and the gate insulating layer 112. The 2-2-th capacitor electrode C2b extends from the sixth gate electrode GE6 and may be disposed to overlap the 2-1-th capacitor electrode C2a. The 2-2-th capacitor electrode C2b may be electrically connected to the sixth gate electrode GE6 of the sixth transistor T6 and the second source electrode SE2.

The 2-3-th capacitor electrode C2c is disposed on the first interlayer insulating layer 113. The 2-3-th capacitor electrode C2c may be configured by a first layer C2c1 and a second layer C2c2. The first layer C2c1 of the 2-3-th capacitor electrode C2c has an island shaped pattern which is formed on the same layer as the 1-2-th capacitor electrode C1b with the same material. The first layer C2c1 may be disposed to overlap the 2-1-th capacitor electrode C2a and the 2-2-th capacitor electrode C2b with the first interlayer insulating layer 113 therebetween.

The second layer C2c2 of the 2-3-th capacitor electrode C2c is disposed on the second interlayer insulating layer 114. The second layer C2c2 extends from the sixth source electrode SE6 and may be connected to the first layer C2c1 through the contact hole of the second interlayer insulating layer 114.

The first scan line SL1, the second scan line SL2, and the emission control signal line EL are disposed on the gate insulating layer 112. The first scan line SL1, the second scan line SL2, and the emission control signal line EL may extend in the row direction and may be disposed along the plurality of sub pixels SP disposed on the same row.

The first scan line SL1 is integrally formed with the first gate electrode GE1, the second gate electrode GE2, and the seventh gate electrode GE7 to transmit a scan signal to the first transistor T1, the second transistor T2, and the seventh transistor T7 and turn on or turn off the first transistor T1, the second transistor T2, and the seventh transistor T7. The second scan line SL2 is integrally formed with the fifth gate electrode GE5 to transmit a scan signal to the fifth transistor T5 and turn on or turn off the fifth transistor T5. The emission control signal line EL is integrally formed with the third gate electrode GE3 and the fourth gate electrode GE4 to transmit the emission control signal to the third transistor T3 and the fourth transistor T4 and turn on or turn off the third transistor T3 and the fourth transistor T4.

The reference line RL is disposed on the first interlayer insulating layer 113. The reference line RL extends in a row direction and may be disposed along the plurality of sub pixels SP disposed on the same row. The reference line RL may be electrically connected to the fifth source electrode SE5 through a contact hole formed in the second interlayer insulating layer 114.

A gate driving line GVL may be further disposed on the first gate insulating layer 113. For example, the first gate power line VGHL may extend to the row direction on the first substrate 110 and may be disposed to be adjacent to the reference line RL. The second gate power line VGLL may extend to the row direction on the first substrate 110 and may be disposed to be adjacent to the first scan line SL1.

The data line DL, the high potential power line VL1, and the low potential power line VL2 are disposed on the second interlayer insulating layer 114. The data line DL, the high potential power line VL1, and the low potential power line VL2 may extend to the column direction and may be disposed along the plurality of sub pixels SP disposed in the same column.

In the meantime, even though it is not illustrated in the drawing, the gate driver GD disposed in the gate driving area GA may include a circuit for outputting a scan signal. For example, the gate driver may include a plurality of gate driving transistors and/or capacitors, like the pixel circuit. Here, active layers of the plurality of gate driving transistors of the gate driver may be formed of a semiconductor material, such as an oxide semiconductor, amorphous silicon, or polysilicon, but are not limited thereto. The active layers of the plurality of gate driving transistors may be formed of the same material or different materials from each other. Further, the active layers of the plurality of gate driving transistors of the gate driver may be formed of the same material as active layers of various transistors of the pixel circuit or formed of different materials from each other. Further, the active layers of the plurality of transistors included in the pixel circuit may be formed of the same material or different materials from each other.

Referring to FIG. 7, a first passivation layer 115a is disposed on the first transistor T1, the second transistor T2, the third transistor T3, the fourth transistor T4, the fifth transistor T5, the sixth transistor T6, the seventh transistor T7, the first capacitor C1, and the second capacitor C2. The first passivation layer 115a is an insulating layer which protects components below the first passivation layer 115a and may be configured by an inorganic material, such as silicon oxide SiOx or silicon nitride SiNx, but is not limited thereto.

A first planarization layer 116a is disposed on the first passivation layer 115a. The first planarization layer 116a may planarize an upper portion of the pixel circuit including the sixth transistor T6. The first planarization layer 116a may be configured by a single layer or a double layer, and for example, configured by benzocyclobutene or an acrylic organic material, but is not limited thereto.

Referring to FIGS. 6 and 7 together, a reflection plate RF is disposed in each of the plurality of sub pixels SP on the first planarization layer 116a. The reflection plate RF is a configuration which reflects light emitted from the plurality of light emitting diodes 130 above the first substrate 110 and may be formed with a shape corresponding to each of the plurality of sub pixels SP. One reflection plate RF may be disposed to cover the most area of one sub pixel SP. The reflection plate RF may reflect the light emitted from the light emitting diode 130 and may be also used as an electrode which electrically connects the light emitting diode 130 and the pixel circuit. Therefore, the reflection plate RF may include various conductive layers in consideration of a light reflection efficiency and a resistance. For example, the reflection plate RF may use an opaque conductive layer such as silver (Ag), aluminum (Al), molybdenum (Mo), titanium (Ti), or an alloy thereof and a transparent conductive layer such as indium tin oxide, but the structure of the reflection plate RF is not limited thereto.

The reflection plate RF includes a first reflection plate RF1 corresponding to the first sub pixel SP1, a second reflection plate RF2 corresponding to the second sub pixel SP2, a third reflection plate RF3 corresponding to the third sub pixel SP3, and a fourth reflection plate RF4 corresponding to the fourth sub pixel SP4.

The first reflection plate RF1 includes a 1-1-th reflection plate RF1a overlapping most of the first sub pixel SP1 and a 1-2-th reflection plate RF1b overlapping the red light emitting diode 130R of the first sub pixel SP1.

A 1-1-th reflection plate RF1a may reflect light emitted from the red light emitting diode 130R above the red light emitting diode 130R. The 1-1-th reflection plate RF1a may be electrically connected to the sixth source electrode SE6 of the sixth transistor T6 through a first contact hole CH1 of the first planarization layer 116a and the first passivation layer 115a. Therefore, the 1-1-th reflection plate RF1a may electrically connect the sixth transistor T6 and the first electrode 134 of the red light emitting diode 130R.

The 1-2-th reflection plate RF1b may reflect light emitted from the red light emitting diode 130R above the red light emitting diode 130R. The 1-2-th reflection plate RF1b may serve as an electrode which electrically connects the second electrode 135 of the red light emitting diode 130R and the high potential power line VL1.

The second reflection plate RF2 includes a 2-1-th reflection plate RF2a overlapping most of the second sub pixel SP2 and a 2-2-th reflection plate RF2b overlapping the red light emitting diode 130R of the second sub pixel SP2.

The 2-1-th reflection plate RF2a may reflect light emitted from the red light emitting diode 130R above the red light emitting diode 130R. The 2-1-th reflection plate RF2a is electrically connected to the sixth source electrode SE6 of the sixth transistor T6 through the first contact hole CH1 to electrically connect the sixth transistor T6 and the first electrode 134 of the red light emitting diode 130R.

The 2-2-th reflection plate RF2b may be used as an electrode which reflects the light emitted from the red light emitting diode 130R above the red light emitting diode 130R and electrically connects the second electrode 135 of the red light emitting diode 130R to the high potential power line VL1.

The third reflection plate RF3 may be formed as one third reflection plate RF3 which overlaps the entire third sub pixel SP3. The third reflection plate RF3 may reflect light emitted from the green light emitting diode 130G of the third sub pixel SP3 above the green light emitting diode 130G. The third reflection plate RF3 may electrically connect the sixth source electrode SE6 of the sixth transistor T6 and the first electrode 134 of the green light emitting diode 130G through the first contact hole CH1.

The fourth reflection plate RF4 may be formed as one fourth reflection plate RF4 which overlaps the entire fourth sub pixel SP4. The fourth reflection plate RF4 may reflect light emitted from the blue light emitting diode 130B of the fourth sub pixel SP4 above the blue light emitting diode 130B. The fourth reflection plate RF4 may electrically connect the sixth source electrode SE6 of the sixth transistor T6 and the first electrode 134 of the blue light emitting diode 130B through the first contact hole CH1.

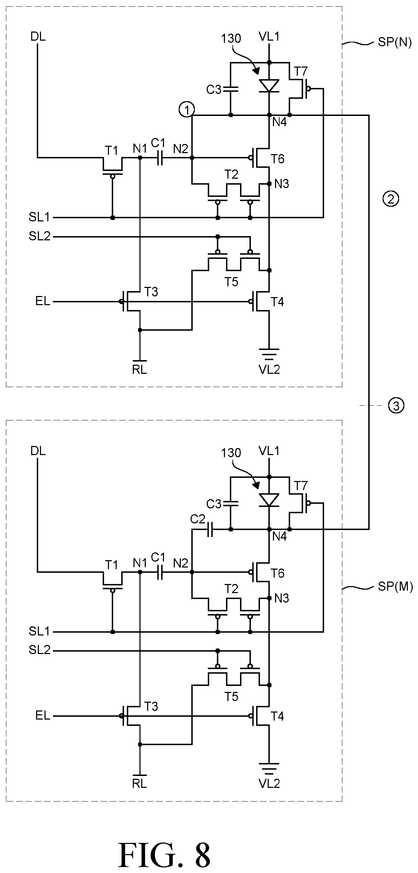

At this time, the 1-1-th reflection plate RF1a, the 2-1-th reflection plate RF2a, the third reflection plate RF3, and the fourth reflection plate RF4 which occupies the most area of the plurality of sub pixels SP may be electrically connected to the first electrode 134 which is a cathode of the light emitting diode 130. When a defect occurs in a specific sub pixel SP, the 1-1-th reflection plate RF1a, the 2-1-th reflection plate RF2a, the third reflection plate RF3, and the fourth reflection plate RF4 are connected to the 1-1-th reflection plate RF1a, the 2-1-th reflection plate RF2a, the third reflection plate RF3, and the fourth reflection plate RF4 of an adjacent sub pixel SP. Therefore, the light emitting diode 130 of a defective sub pixel SP may be electrically connected to the sixth transistor T6 of the adjacent sub pixel SP. Therefore, the reflection plate RF of each sub pixel SP is electrically connected to the sixth transistor T6 of the adjacent sub pixel SP to repair the light emitting diode 130 of the defective sub pixel SP to normally operate. A repair method of a defective sub pixel SP using the 1-1-th reflection plate RF1a, the 2-1-th reflection plate RF2a, the third reflection plate RF3, and the fourth reflection plate RF4 will be described in detail below with reference to FIGS. 8 to 11B.

In the meantime, even though it has been described that the first sub pixel SP1 and the second sub pixel SP2 are formed with two reflection plates RF and the third sub pixel SP3 and the fourth sub pixel SP4 are formed with one reflection plate RF, the reflection plate RF may be designed in various manners. For example, only one reflection plate RF may be disposed in all the plurality of sub pixels SP, like the third sub pixel SP3 and the fourth sub pixel SP4 or a plurality of reflection plates RF may be disposed in all the sub pixels like the first sub pixel SP1 and the second sub pixel SP2, but the reflection plate is not limited thereto.

Further, it has been described that the red light emitting diode 130R of each of the first sub pixel SP1 and the second sub pixel SP2 is electrically connected to the high potential power line VL1 through the 1-2-th reflection plate RF1b and the 2-2-th reflection plate RF2b. However, all the red light emitting diode 130R, the green light emitting diode 130G, and the blue light emitting diode 130B may be separately connected to the high potential power line VL1 without the reflection plate RF, but are not limited thereto.

A second passivation layer 115b is disposed on the plurality of reflection plates RF. The second passivation layer 115b is an insulating layer which protects components below the second passivation layer 115b and may be configured by a single layer or a double layer of silicon oxide SiOx or silicon nitride SiNx, but is not limited thereto.

An adhesive layer AD is disposed on the second passivation layer 115b. The adhesive layer AD is formed on the entire surface of the first substrate 110 to fix the light emitting diode 130 disposed on the adhesive layer AD. The adhesive layer AD may be formed of a photo curable adhesive material which is cured by light. For example, the adhesive layer AD may be formed of an acrylic material including a photoresist, but is not limited thereto. The adhesive layer AD may be formed on the entire surface of the first substrate 110 excluding a pad area in which the first pad electrode PAD1 is disposed.

The plurality of light emitting diodes 130 is disposed in each of the plurality of sub pixels SP on the adhesive layer AD. The light emitting diode 130 is an element which emits light by a current and may include a red light emitting diode 130R which emits red light, a green light emitting diode 130G which emits green light, and a light emitting diode 130 which emits blue light and implement light with various colors including white by a combination thereof. For example, the light emitting diode 130 may be a light emitting diode (LED) or a micro LED, but is not limited thereto.

One red light emitting diode 130R is disposed in each of the first sub pixel SP1 and the second sub pixel SP2, one pair of green light emitting diodes 130G is disposed in the third sub pixel SP3, and one pair of blue light emitting diodes 130B is disposed in the fourth sub pixel SP4. That is, two red light emitting diodes 130R, two green light emitting diodes 130G, and two light emitting diodes 130B may be disposed in one pixel PX. At this time, each of the red light emitting diodes 130R is connected to the sixth transistor T6 of each of the first sub pixel SP1 and the second sub pixel SP2 to be individually driven. In contrast, one pair of green light emitting diodes 130G of the third sub pixel SP3 and one pair of blue light emitting diodes 130B of the fourth sub pixel SP4 are connected to one sixth transistor T6 in parallel to be driven.

The plurality of light emitting diodes 130 includes a first semiconductor layer 131, an emission layer 132, a second semiconductor layer 133, a first electrode 134, a second electrode 135, and an encapsulation layer 136.

The first semiconductor layer 131 is disposed on the adhesive layer AD and the second semiconductor layer 133 is disposed on the first semiconductor layer 131. The first semiconductor layer 131 and the second semiconductor layer 133 may be layers formed by doping n-type and p-type impurities into a specific material. For example, the first semiconductor layer 131 and the second semiconductor layer 133 may be layers doped with n type and p type impurities into a material such as gallium nitride (GaN), indium aluminum phosphide (InAlP), or gallium arsenide (GaAs). The p-type impurity may be magnesium (Mg), zinc (Zn), beryllium (Be), and the like, and the n-type impurity may be silicon (Si), germanium, tin (Sn), and the like0, but are not limited thereto.

The emission layer 132 is disposed between the first semiconductor layer 131 and the second semiconductor layer 133. The emission layer 132 is supplied with holes and electrons from the first semiconductor layer 131 and the second semiconductor layer 133 to emit light. The emission layer 132 may be formed by a single layer or a multi-quantum well (MQW) structure, and for example, may be formed of indium gallium nitride (InGaN) or gallium nitride (GaN), but is not limited thereto.

The first electrode 134 is disposed on the first semiconductor layer 131. The first electrode 134 is an electrode which electrically connects the sixth transistor T6 and the first semiconductor layer 131. In this case, the first semiconductor layer 131 is a semiconductor layer doped with an n-type impurity and the first electrode 134 may be a cathode. The first electrode 134 may be disposed on a top surface of the first semiconductor layer 131 which is exposed from the emission layer 132 and the second semiconductor layer 133. The first electrode 134 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu) or an alloy thereof, but is not limited thereto.

The second electrode 135 is disposed on the second semiconductor layer 133. The second electrode 135 may be disposed on the top surface of the second semiconductor layer 133. The second electrode 135 is an electrode which electrically connects the high potential power line VL1 and the second semiconductor layer 133. In this case, the second semiconductor layer 133 is a semiconductor layer doped with a p-type impurity and the second electrode 135 may be an anode. The second electrode 135 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu) or an alloy thereof, but is not limited thereto.

Next, the encapsulation layer 136 which encloses the first semiconductor layer 131, the emission layer 132, the second semiconductor layer 133, the first electrode 134, and the second electrode 135 is disposed. The encapsulation layer 136 is formed of an insulating material to protect the first semiconductor layer 131, the emission layer 132, and the second semiconductor layer 133. In the encapsulation layer 136, a contact hole which exposes the first electrode 134 and the second electrode 135 is formed to electrically connect a first connection electrode CE1 and a second connection layer CE2 to the first electrode 134 and the second electrode 135.

In the meantime, a part of the side surface of the first semiconductor layer 131 may be exposed from the encapsulation layer 136. The light emitting diode 130 manufactured on the wafer is separated from the wafer to be transferred onto the display panel PN. However, during the process of separating the light emitting diode 130 from the wafer, a part of the encapsulation layer 136 may be torn. For example, a part of the encapsulation layer 136 which is adjacent to a lower edge of the first semiconductor layer 131 of the light emitting diode 130 is torn during the process of separating the light emitting diode 130 from the wafer. Accordingly, a part of a lower side surface of the first semiconductor layer 131 may be exposed to the outside. However, even though the lower portion of the light emitting diode 130 is exposed from the encapsulation layer 136, the first connection electrode CE1 and the second connection electrode CE2 are formed after forming the second planarization layer 116b and the third planarization layer 116c which cover the side surface of the first semiconductor layer 131. Accordingly, a short problem may be reduced.

Next, the second planarization layer 116b and the third planarization layer 116c are disposed on the adhesive layer AD and the light emitting diode 130.

The second planarization layer 116b overlaps a part of side surfaces of the plurality of light emitting diodes 130 to fix and protect the plurality of light emitting diodes 130. The second planarization layer 116b may be formed using a halftone mask. Therefore, the second planarization layer 116b may be formed to have a step.

Specifically, a part of the second planarization layer 116b which is relatively adjacent to the light emitting diode 130 may be formed to have a smaller thickness and a part which is farther from the light emitting diode 130 may be formed to have a larger thickness. A part of the second planarization layer 116b which is adjacent to the light emitting diode 130 may be disposed to enclose the light emitting diode 130 and also may be in contact with a side surface of the light emitting diode 130. Therefore, a torn part of the encapsulation layer 136 which protects a side surface of the first semiconductor layer 131 of the light emitting diode 130 during the process of separating the light emitting diode 130 from the wafer to be transferred onto the display panel PN may be covered by the second planarization layer 116b. By doing this, contacts and short problems of the connection electrodes CE1 and CE2 and the first semiconductor layer 131 later may be suppressed.

The third planarization layer 116c is formed to cover upper portions of the second planarization layer 116b and the light emitting diode 130 and a contact hole which exposes the first electrode 134 and the second electrode 135 of the light emitting diode 130 may be formed. The first electrode 134 and the second electrode 135 of the light emitting diode 130 are exposed from the third planarization layer 116c and the third planarization layer 116c is partially disposed in an area between the first electrode 134 and the second electrode 135 to reduce a short problem. The second planarization layer 116b and the third planarization layer 116c may be configured by a single layer or a double layer, and for example, may be formed of a photoresist or an acrylic organic material, but are not limited thereto.

In the meantime, the third planarization layer 116c may cover only the light emitting diode 130 and an area adjacent to the light emitting diode 130. The third planarization layer 116c may be disposed in an area of the sub pixel SP enclosed by the bank BB and may be disposed in an island shape. A bank BB is disposed in a part of the top surface of the second planarization layer 116b and the third planarization layer 116c may be disposed in the other part of the top surface of the second planarization layer 116b.

The first connection electrode CE1 and the second connection electrode CE2 are disposed on the third planarization layer 116c. The first connection electrode CE1 is an electrode which electrically connects the second electrode 135 of the light emitting diode 130 and the high potential power line VL1. The first connection electrode CE1 may be electrically connected to the second electrode 135 of the light emitting diode 130 through a contact hole formed in the third planarization layer 116c.

The second connection electrode CE2 is an electrode which electrically connects the first electrode 134 of the light emitting diode 130 and the sixth transistor T6. The second connection electrode CE2 may be connected to the 1-1-th reflection plate RF1a, the 2-1-th reflection plate RF2a, the third reflection plate RF3, and the fourth reflection plate RF4 of each of the plurality of sub pixels SP through contact holes formed in the third planarization layer 116c, the second planarization layer 116b, the adhesive layer AD, and the second passivation layer 115b. At this time, the 1-1-th reflection plate RF1a, the 2-1-th reflection plate RF2a, the third reflection plate RF3, and the fourth reflection plate RF4 are also connected to the sixth source electrode SE6 of the sixth transistor T6 so that the sixth source electrode SE6 of the sixth transistor T6 and the first electrode 134 of the light emitting diode 130 may be electrically connected to each other.

In the meantime, in the drawing, it is illustrated that the first electrode 134, the second connection electrode CE2, and the reflection plate RF are electrically connected to the sixth source electrode SE6 of the sixth transistor T6. However, the first electrode 134, the second connection electrode CE2, and the reflection plate RF may be connected to the sixth drain electrode DE6 of the sixth transistor T6, but it is not limited thereto.

A bank BB is disposed on the first connection electrode CE1, the second connection electrode CE2, and the second planarization layer 116b exposed from the third planarization layer 115c. The bank BB may be disposed to be spaced apart from the light emitting diode 130 with a predetermined interval and overlap at least partially the reflection plate RF. For example, the bank BB may cover a part of the second connection electrode CE2 formed in the contact holes of the third planarization layer 116c and the second planarization layer 116b. Further, the bank BB may be disposed on the second planarization layer 116b with a predetermined interval from the light emitting diode 130. In this case, the bank BB and the third planarization layer 116c may be spaced apart from each other on a part of the second planarization layer 116b having a smaller thickness. That is, an end of the bank BB and an end of the third planarization layer 116c may be disposed on a part of the second planarization layer 116b having a smaller thickness formed by a halftone mask process to be spaced apart from each other. The bank BB may be formed of an opaque material to reduce color mixture between the plurality of sub pixels SP and for example, may be formed of black resin, but is not limited thereto.

In the meantime, a thickness of a part of the bank BB which is formed in the contact holes of the third planarization layer 116c and the second planarization layer 116b to cover a part of the second connection electrode CE2 and a thickness of a part disposed on the second planarization layer 116b may be different from each other. Specifically, when the part of the bank BB covers a part of the second connection electrode CE2 formed in the contact holes of the third planarization layer 116c and the second planarization layer 116b, since the contact hole is formed from the second passivation layer 115b to the third planarization layer 116c, the bank BB may be disposed below the light emitting diode 130, that is, disposed to be lower than the light emitting diode 130. Therefore, the thickness of the part of the bank BB which covers a part of the second connection electrode CE2 formed in the contact holes of the third planarization layer 116c and the second planarization layer 116b may be larger than the thickness of a part of the bank BB disposed on the second planarization layer 116b.

A first protection layer 117 is disposed on the first connection electrode CE1, the second connection electrode CE2, and the bank BB. The first protection layer 117 is a layer which protects components below the first protection layer 117. The first protection layer 117 may be configured by a single layer or a double layer, and for example, configured by benzocyclobutene, a light-transmitting epoxy, a photoresist, or an acrylic organic material, but is not limited thereto.

A plurality of first pad electrodes PAD1 is disposed in a first pad area PA1 and a second pad area PA2 of the first substrate 110. Each of the plurality of first pad electrodes PAD1 may be configured by a plurality of conductive layers. For example, each of the plurality of first pad electrodes PAD1 includes a first conductive layer PE1a, a second conductive layer PE1b, and a third conductive layer PE1c.

First, the first conductive layer PE1a is disposed on the second interlayer insulating layer 114. The first conductive layer PE1a may be formed of the same conductive material as the sixth source electrode SE6 and the sixth drain electrode DE6 and for example, may be configured by copper (Cu), aluminum (Al), molybdenum (Mo), nickel (Ni), titanium (Ti), chrome (Cr), or an alloy thereof, but is not limited thereto.

The first passivation layer 115a is disposed on the first conductive layer PE1a and the second conductive layer PE1b is disposed on the first passivation layer 115a. The second conductive layer PE1b may be formed of the same conductive material as the reflection plate RF and for example, may be configured by silver (Ag), aluminum (Al), molybdenum (Mo), or an alloy thereof, but is not limited thereto.

The third conductive layer PE1c is disposed on the second conductive layer PE1b. The third conductive layer PE1c may be formed of the same conductive material as the first connection electrode CE1 and the second connection electrode CE2, and for example, a transparent conductive material, such as indium tin oxide (ITO) or indium zinc oxide (IZO), but is not limited thereto.

At this time, even though it is not illustrated in the drawings, some of the plurality of conductive layers of the first pad electrode PAD1 are electrically connected to a plurality of wiring lines on the first substrate 110 to supply various signals to a plurality of wiring lines and a plurality of sub pixels SP. For example, the first conductive layer PE1a and/or the second conductive layer PE1b of the first pad electrode PAD1 is connected to the data line DL, the high potential power line VL1, and the low potential power line VL2 disposed in the active area AA to transmit signals thereto.

A first metal layer ML1, a second metal layer ML2, and a plurality of insulating layers may be disposed together below the first pad electrode PAD1. The first metal layer ML1, the second metal layer ML2, and the plurality of insulating layers are disposed below the first pad electrode PAD1 to adjust a step of the first pad electrode PAD1. For example, the buffer layer 111, the gate insulating layer 112, the first metal layer ML1, the first interlayer insulating layer 113, and the second metal layer ML2 may be sequentially disposed between the first pad electrode PAD1 and the first substrate 110. The first metal layer ML1 may be formed of the same conductive material as the sixth gate electrode GE6 and the second metal layer ML2 may be formed of the same conductive material as a 1-2-th capacitor electrode C1b. However, the plurality of insulating layers, the first metal layer ML1, and the second metal layer ML2 below the first pad electrode PAD1 may be omitted depending on a design and are not limited thereto.

A second substrate 120 is disposed below the first substrate 110. The second substrate 120 is a substrate which supports components disposed below the display device 100 and may be an insulating substrate. For example, the second substrate 120 may be formed of glass or resin. Further, the second substrate 120 may include polymer or plastic. The second substrate 120 may be formed of the same material as the first substrate 110. In some exemplary embodiments, the second substrate 120 may be formed of a plastic material having flexibility.

A bonding layer BDL is disposed between the first substrate 110 and the second substrate 120. The bonding layer BDL may be formed of a material which is cured by various curing methods to bond the first substrate 110 and the second substrate 120. The bonding layer BDL may be disposed only in a partial area between the first substrate 110 and the second substrate 120 or may be disposed in the entire area.

A plurality of second pad electrodes PAD2 is disposed on a rear surface of the second substrate 120. The plurality of second pad electrodes PAD2 is electrodes which transmit a signal from a driving component disposed on the rear surface of the second substrate 120 to a plurality of side lines SRL and a plurality of first pad electrodes PAD 1 and a plurality of wiring lines on the first substrate 110. The plurality of second pad electrodes PAD2 is disposed in an end portion of the second substrate 120 in the non-active area NA to be electrically connected to the side line SRL which covers the end portion of the second substrate 120.

At this time, the plurality of second pad electrodes PAD2 may be also disposed so as to correspond to the first pad area PA1 and the second pad area PA2. The plurality of first pad electrodes PAD1 may be disposed to correspond to the plurality of second pad electrodes PAD2, respectively, and then the first pad electrode PAD1 and the second pad electrode PAD2 which overlap each other may be electrically connected through the side line SRL.

Each of the plurality of second pad electrodes PAD2 includes a plurality of conductive layers. For example, each of the plurality of second pad electrodes PAD2 includes a fourth conductive layer PE2a, a fifth conductive layer PE2b, and a sixth conductive layer PE2c.

First, the fourth conductive layer PE2a is disposed below the second substrate 120. The fourth conductive layer PE2a may be configured by a conductive material such as copper (Cu), aluminum (Al), molybdenum (Mo), nickel (Ni), titanium (Ti), chrome (Cr), or an alloy thereof, but is not limited thereto.

The fifth conductive layer PE2b is disposed below the fourth conductive layer PE2a. The fifth conductive layer PE2b may be configured by a conductive material, such as copper (Cu), aluminum (Al), molybdenum (Mo), nickel (Ni), titanium (Ti), chrome (Cr), or an alloy thereof, but is not limited thereto.

The sixth conductive layer PE2c is disposed below the fifth conductive layer PE2b. The sixth conductive layer PE2c may be formed of a conductive material, for example, a transparent conductive material, such as indium tin oxide (ITO) or indium zinc oxide (IZO), but is not limited thereto.

The second protection layer 121 is disposed in the remaining area of the second substrate 120. The second protection layer 121 may protect various wiring lines and driving components formed on the second substrate 120. The second protection layer 121 may be configured by a single layer or a double layer, and for example, configured by benzocyclobutene, a light-transmitting epoxy, a photoresist, or an acrylic organic insulating material, but is not limited thereto.

Even though it is not illustrated in the drawing, a driving component including a plurality of flexible films and a printed circuit board may be disposed on a rear surface of the second substrate 120. The plurality of flexible films is components in which various components such as a data driver IC are disposed on a base film having a ductility to supply signals to the plurality of sub pixels SP. The printed circuit board is a component which is electrically connected to the plurality of flexible films to supply signals to the driving IC. On the printed circuit board, various components for supplying various signals to the driving IC may be disposed.

For example, the fourth conductive layer PE2a and/or the fifth conductive layer PE2b of the second pad electrode PAD2 extend to the plurality of flexible films disposed on the rear surface of the second substrate 120 to be electrically connected to the plurality of flexible films. The plurality of flexible films may supply various signals to the plurality of side lines SRL, the plurality of first pad electrodes PAD1, the plurality of wiring lines, and the plurality of sub pixels SP through the second pad electrode PAD2. Therefore, the signal from the driving component may be transmitted to a plurality of wiring lines and the plurality of sub pixels SP on the front surface of the first substrate 110 through the plurality of second pad electrodes PAD2 of the second substrate 120, the side line SRL, and the plurality of first pad electrodes PAD1 of the first substrate 110.

Next, the plurality of side lines SRL is disposed on the side surfaces of the first substrate 110 and the second substrate 120. The plurality of side lines SRL may electrically connect the plurality of first pad electrodes PAD1 formed on the top surface of the first substrate 110 and the plurality of second pad electrodes PAD2 formed on the rear surface of the second substrate 120. The plurality of side lines SRL may be disposed so as to enclose the side surface of the display device 100. Each of the plurality of side lines SRL may cover the first pad electrode PAD1 at an end portion of the first substrate 110, a side surface of the first substrate 110, a side surface of the second substrate 120, and the second pad electrode PAD2 at an end portion of the second substrate 120. For example, the plurality of side lines SRL may be formed by a pad printing method using a conductive ink, for example, including silver (Ag), copper (Cu), molybdenum (Mo), and chrome (Cr).

A side insulating layer 140 which covers the plurality of side lines SRL is disposed. The side insulating layer 140 may be formed on the top surface of the first substrate 110, the side surface of the first substrate 110, the side surface of the second substrate 120, and the rear surface of the second substrate 120 to cover the side line SRL. The side insulating layer 140 may protect the plurality of side lines SRL.

In the meantime, when the plurality of side lines SRL is formed of a metal material, there may be a problem in that external light is reflected from the plurality of side lines SRL or light emitted from the light emitting diode 130 is reflected from the plurality of side lines SRL to be visibly recognized by the user. Therefore, the side insulating layer 140 is configured to include a black material to suppress reflection of the external light. For example, the side insulating layer 140 may be formed by a pad printing method using an insulating material including a black material, for example, a black ink.

A seal member 150 which covers the side insulating layer 140 is disposed. The seal member 150 is disposed so as to enclose the side surface of the display device 100 to protect the display device 100 from external impacts, moisture, oxygen, and the like. For example, the seal member 150 may be formed of polyimide (PI), poly urethane, epoxy, acryl based insulating material, or the like, but is not limited thereto.

An optical film MF is disposed on the seal member 150, the side insulating layer 140, and the first protection layer 117. The optical film MF may be a functional film which implements a higher quality of images while protecting the display device 100. For example, the optical film MF may be an anti-scattering film, an anti-glare film, an anti-reflecting film, a low-reflecting film, an Oled transmittance controllable film, a polarizer, or the like, but is not limited thereto.

In the meantime, an edge of the seal member 150 and an edge of the optical film MF may be disposed on the same line. The optical film ML having a larger size is attached above the first substrate 110 during the manufacturing process of the display device 100 and the seal member 150 which covers the side insulating layer 140 may be formed. Thereafter, laser is irradiated on the seal member 150 and the optical film MF so as to correspond to an edge of the display device 100 to cut a part of the seal member 150 and the optical film MF. Accordingly, the size of the display device 100 is adjusted by an outer periphery cutting process of the seal member 150 and the optical film MF and the edge of the display device 100 may be formed to be flat.

Hereinafter, a repair method of the display device 100 according to an exemplary embodiment of the present disclosure will be described with reference to FIGS. 8 to 11B.

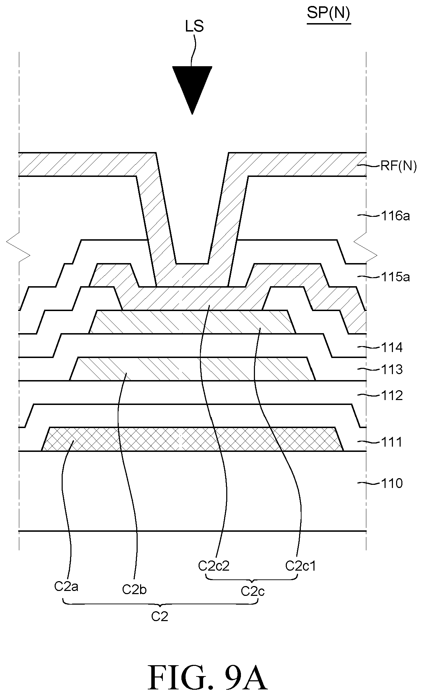

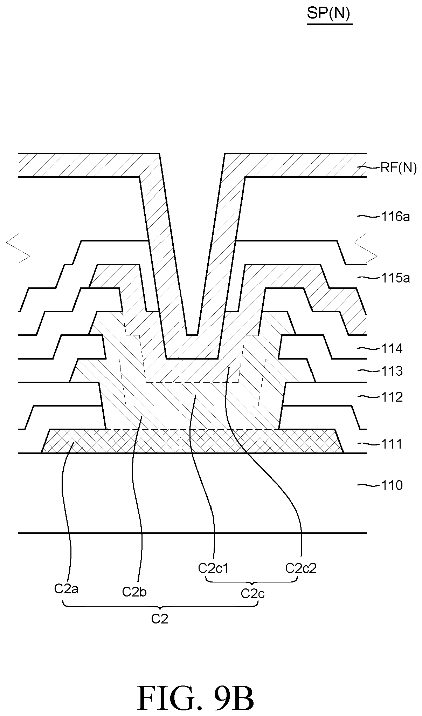

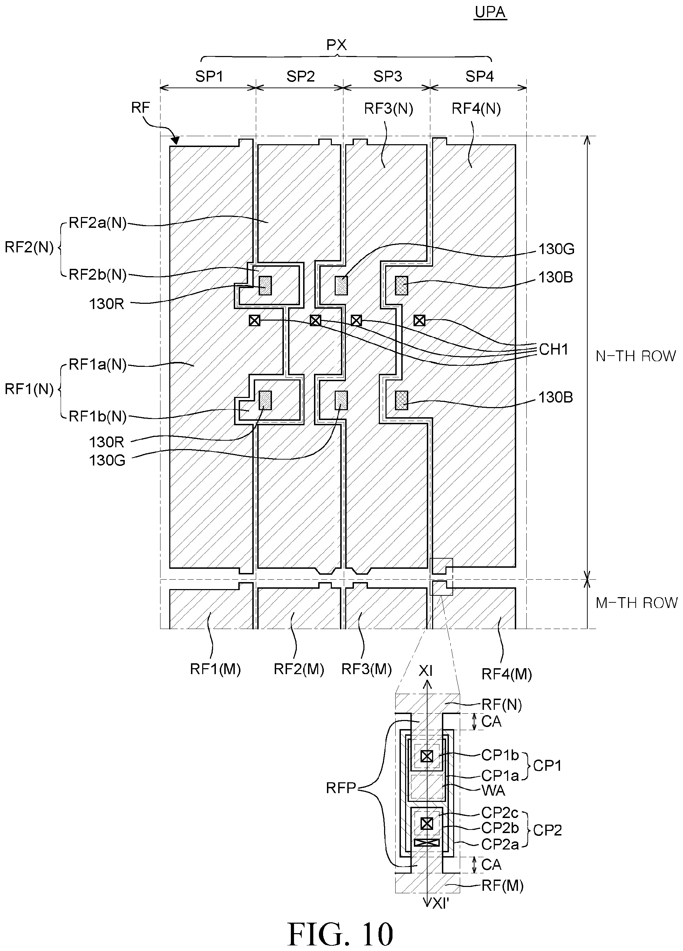

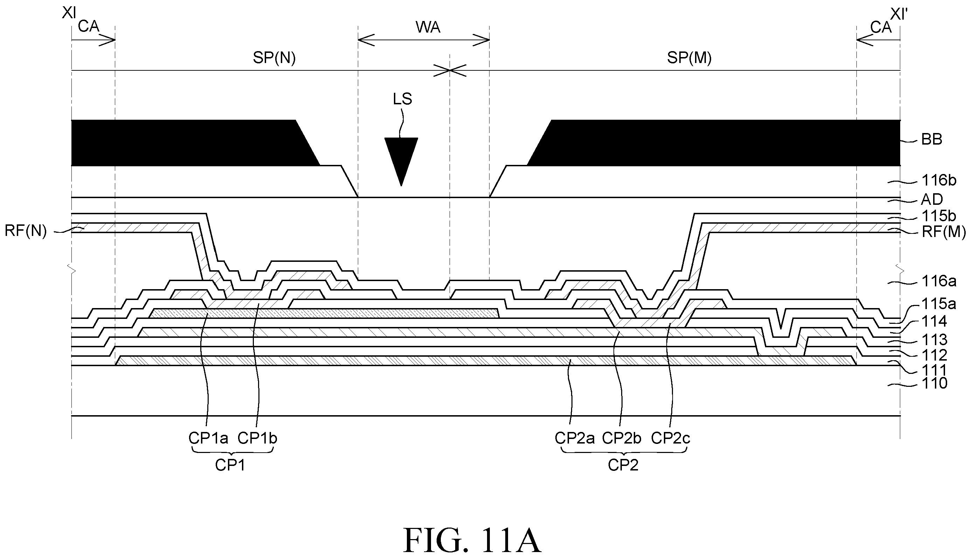

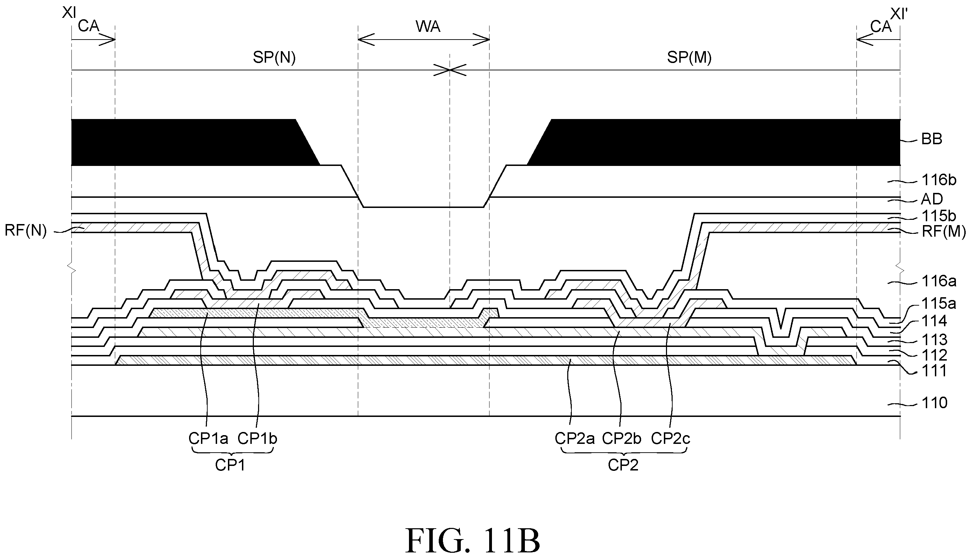

FIG. 8 is a circuit diagram for explaining a repair process of a sub pixel according to an exemplary embodiment of the present disclosure. FIGS. 9A and 9B are cross-sectional views of a second capacitor of a display device according to an exemplary embodiment of the present disclosure. FIG. 10 is an enlarged plan view of a display device according to an exemplary embodiment of the present disclosure. FIGS. 11A and 11B are cross-sectional views taken along the line XI-XI' of FIG. 10. For the convenience of description, in FIGS. 9A, 9B, 11A, and 11B, the second substrate 120 and the bonding layer BDL are not illustrated. Further, the 1-1-th reflection plate RF1a, the 2-1-th reflection plate RF2a, the third reflection plate RF3, and the fourth reflection plate RF4 connected to the first electrode 134 of the light emitting diode 130, among the plurality of reflection plates RF, are denoted by reflection plates RF(N) and RF(M).

Hereinafter, when a defect occurs in a sub pixel SP(N) disposed in an N-th row, among a plurality of rows, the description will be made assuming a case of repairing the sub pixel SP(N) of the N-th row using a sub pixel SP(M) in an M-th row adjacent to the N-th row.

First, when a defect occurs in a specific sub pixel SP, a dark spot or bright spot problem may occur. For example, when a defect occurs in the light emitting diode 130, a short problem may occur in the plurality of transistors and the plurality of capacitors due to foreign materials or static electricity. When the transistor is abnormally driven, a dark spot problem that the light emitting diode 130 does not emit light or a bright spot problem that the light emitting diode 130 continuously emits light may occur. When a defect occurs in a pixel circuit including a plurality of transistors or a plurality of capacitors, the light emitting diode 130 and the defective pixel circuit are separated so as not to allow the light emitting diode 130 to emit light by the defective pixel circuit. Further, a pixel circuit of an adjacent sub pixel SP and the light emitting diode 130 are electrically connected to normally drive the light emitting diode 130.

Specifically, when a defective sub pixel SP is generated, the repair may be performed in the order of a process (1), a process (2), and a process (3). The process (1) is a process of darkening the defective sub pixel SP by performing a welding process on the second capacitor C2. In the process (1), the 2-1-th capacitor electrode C2a, the 2-2-th capacitor electrode C2b, and the 2-3-th capacitor electrode C2c of the second capacitor C2 are connected to each other to short the sixth gate electrode GE6 and the sixth source electrode SE6 of the sixth transistor T6 and may darken the defective sub pixel SP. The process (2) is a process of connecting the light emitting diode 130 and the reflection plate RF of the darkened defective sub pixel SP to the reflection plate RF and the pixel circuit of an adjacent normal sub pixel SP by performing a welding process on the first connection pattern CP1 and the second connection pattern CP2. The light emitting diode 130 of the defective sub pixel SP is electrically connected to the pixel circuit of the normal sub pixel SP by the process (1) to normally drive the light emitting diode 130 of the defective sub pixel SP. The process (3) is a process of separating the light emitting diode 130 of the defective sub pixel SP from the pixel circuit of the normal sub pixel SP when an error occurs again after repairing the defective sub pixel SP. The sub pixel SP having an error may be re-darkened by the process (3).

First, referring to FIGS. 8 to 9B, when a defect occurs in a sub pixel SP(N) in the N-th row, the process (1) of darkening the sub pixel SP(N) of the N-th row by performing a welding process on the second capacitor C2 may be performed. By means of the process (1), the driving current may not flow through the light emitting diode 130 of the sub pixel SP(N) in the N-th row. Specifically, the dark spot problem that the light emitting diode 130 does not emit light or the bright spot problem that the light emitting diode continuously emits light may be caused by the pixel circuit in which defect occurs. Therefore, a welding process may be performed to short a part of the pixel circuit so as not to allow the defective pixel circuit to abnormally drive the light emitting diode 130.

Referring to FIG. 9A, laser LS is irradiated onto the second capacitor C2 to connect the sixth gate electrode GE6 and the sixth source electrode SE6 of the sixth transistor T6 which serves as a driving transistor.

The second capacitor C2 is a capacitor which is connected between the sixth gate electrode GE6 and the sixth source electrode SE6 of the sixth transistor T6 which serves as a driving transistor. The second capacitor includes a 2-2-th capacitor electrode C2b which is connected to the sixth gate electrode GE6 and a 2-1-th capacitor electrode C2a and a 2-3-th capacitor electrode C2c which are disposed above and below the 2-2-th capacitor electrode C2b, respectively, and are connected to the sixth source electrode SE6. Insulating layers 111, 112, and 113 are disposed between the 2-1-th capacitor electrode C2a and the 2-2-th capacitor electrode C2b and between the 2-2-th capacitor electrode C2b and the 2-3-th capacitor electrode C2c so that the 2-1-th capacitor electrode C2a, the 2-2-th capacitor electrode C2b, and the 2-3-th capacitor electrode C2c are spaced apart from each other.

Referring to FIG. 9B, when the welding process is performed by irradiating laser LS onto the second capacitor C2 electrode, the buffer layer 111 and the gate insulating layer 112 between the 2-1-th capacitor electrode C2a and the 2-2-th capacitor electrode C2b and the first interlayer insulating layer 113 between the 2-2-th capacitor electrode C2b and the 2-3-th capacitor electrode C2c are open. Further, the 2-1-th capacitor electrode C2a, the 2-2-th capacitor electrode C2b, and the 2-3-th capacitor electrode C2c are partially melted down to be connected. In this case, the source electrode SE6 and the sixth gate electrode GE6 of the sixth transistor T6 may be shorted by the 2-1-th capacitor electrode C2a, the 2-2-th capacitor electrode C2b, and the 2-3-th capacitor electrode C2c which are connected to each other by the welding process. Accordingly, a voltage difference Vgs between the sixth gate electrode GE6 and the sixth source electrode SE6 may be always 0 V and the sixth transistor T6 may be no longer turned on.

Accordingly, the welding process is performed on the second capacitor C2 of the sub pixel SP(N) of the N-th row in which the defect occurs to connect the 2-1-th capacitor electrode C2a, the 2-2-th capacitor electrode C2b, and the 2-3-th capacitor electrode C2c of the second capacitor C2 and short the sixth gate electrode GE6 and the sixth source electrode SE6 of the sixth transistor T6. Therefore, an erroneous operation of the light emitting diode 130 due to the defective pixel circuit, specifically, a bright spot problem may be suppressed.

Referring to FIGS. 8 and 10 together, after completing the process (1) of welding the second capacitor C2, the process (2) of electrically connecting the first electrode 134 of the light emitting diode 130 of the sub pixel SP(N) of the N-th row which is a defective sub pixel SP and the first electrode 134 of the light emitting diode 130 of the sub pixel SP(M) of the M-th row which is a normal sub pixel SP may be performed. The light emitting diode 130 of the sub pixel SP(N) of the N-th row is electrically connected to the sixth transistor T6 of the sub pixel SP(M) of the M-th row to drive the light emitting diode 130 of the defective sub pixel SP with a pixel circuit of the sub pixel SP(M) of the M-th row. Therefore, the light emitting diode 130 in the N-th row and the light emitting diode 130 in the M-th row are connected to the circuit of the sub pixel SP(M) of the M-th row in parallel to be driven together.

First, the 1-1-th reflection plate RF1a, the 2-1-th reflection plate RF2a, the third reflection plate RF3, and the fourth reflection plate RF4 are disposed so as to cover the most of the sub pixel SP. Therefore, outermost portions of the 1-1-th reflection plate RF1a, the 2-1-th reflection plate RF2a, the third reflection plate RF3, and the fourth reflection plate RF4 may be disposed to be adjacent to a 1-1-th reflection plate RF1a, a 2-1-th reflection plate RF2a, a third reflection plate RF3, and a fourth reflection plate RF4 of the adjacent sub pixel SP, respectively. For example, the third reflection plate RF3(N) of the sub pixel SP(N) of the N-th row and the third reflection plate RF3(M) of the M-th row may be opposite to each other at a boundary of the sub pixels SP.

At this time, when all the plurality of sub pixels SP is normal sub pixels SP, the reflection plate RF of each of the plurality of sub pixels SP may be electrically insulated from a reflection plate RF of an adjacent sub pixel SP.

However, when some sub pixels SP of the plurality of sub pixels SP are defective sub pixels SP, a reflection plate RF of a defective sub pixel SP and a reflection plate RF of a sub pixel SP adjacent to the defective sub pixel SP may be electrically connected.

Specifically, the reflection plate RF(N) of the sub pixel SP(N) of the N-th row and the reflection plate RF(M) of the sub pixel SP(M) of the M-th row which are adjacent to each other are electrically connected to electrically connect the first electrodes 134 of the light emitting diodes 130 of the sub pixel SP(N) of the N-th row and the sub pixel SP(M) of the M-th row, respectively. As described above with reference to FIGS. 4 to 7, the 1-1-th reflection plate RF1a, the 2-1-th reflection plate RF2a, the third reflection plate RF3, and the fourth reflection plate RF4 of the plurality of sub pixels SP may be electrically connected to the first electrode 134 of the light emitting diode 130. Therefore, the sub pixel SP(N) of the N-th row may be repaired by connecting the 1-1-th reflection plate RF1a, the 2-1-th reflection plate RF2a, the third reflection plate RF3, and the fourth reflection plate RF4 of each of the normal sub pixel SP(M) of the M-th row and the defective sub pixel SP(N) of the N-th row.

For example, when a first sub pixel SP1(N) of the N-th row is defective, a 1-1-th reflection plate RF1a(N) of the N-th row may be electrically connected to a 1-1-th reflection plate RF1a(M) of the M-th row. When a second sub pixel SP2(N) of the N-th row is defective, a 2-1-th reflection plate RF2a(N) of the N-th row may be electrically connected to a 2-1-th reflection plate RF2a(M) of the M-th row. When a third sub pixel SP3(N) of the N-th row is defective, a third reflection plate RF3(N) of the N-th row may be electrically connected to a third reflection plate RF3(M) of the M-th row. Finally, when a fourth sub pixel SP4(N) of the N-th row is defective, a fourth reflection plate RF4(N) of the N-th row may be electrically connected to a fourth reflection plate RF4(M) of the M-th row.

Referring to FIGS. 11A and 11B, a first connection pattern CP1 and a second connection pattern CP2 are disposed so as to electrically connect a reflection plate RF(N) of the N-th row and a reflection plate RF(M) of the M-th row. The reflection plate RF(N) of the sub pixel SP(N) of the N-th row and a reflection plate RF(M) of the sub pixel SP(M) of the M-th row may be connected by performing the welding process of the first connection pattern CP1 and the second connection pattern CP2.

The first connection pattern CP1 is an electrode which is electrically connected to each of a 1-1-th reflection plate RF1a(N), a 2-1-th reflection plate RF2a(N), a third reflection plate RF3(N), and a fourth reflection plate RF4(N) of the sub pixel SP(N) of the N-th row. The second connection pattern CP2 is an electrode which is electrically connected to each of a 1-1-th reflection plate RF1a(M), a 2-1-th reflection plate RF2a(M), a third reflection plate RF3(M), and a fourth reflection plate RF4(M) of the M-th row.

The first connection pattern CP1 may be connected to lower portions of the 1-1-th reflection plate RF1a, the 2-1-th reflection plate RF2a, the third reflection plate RF3, and the fourth reflection plate RF4. The second connection pattern CP2 may be connected to upper portions of the 1-1-th reflection plate RF1a, the 2-1-th reflection plate RF2a, the third reflection plate RF3, and the fourth reflection plate RF4. Therefore, one reflection plate RF may be connected to both the first connection pattern CP1 connected to the lower portion and the second connection pattern CP2 connected to the upper portion.

Each of the 1-1-th reflection plate RF1a, the 2-1-th reflection plate RF2a, the third reflection plate RF3, and the fourth reflection plate RF4 may include a protrusion RFP protruding toward the first connection pattern CP1 and the second connection pattern CP2. For example, each of the 1-1-th reflection plate RF1a, the 2-1-th reflection plate RF2a, the third reflection plate RF3, and the fourth reflection plate RF4 may include a protrusion RFP protruding toward the first connection pattern CP1 and the second connection pattern CP2 from each of a lower edge and an upper edge. The protrusion RFP of each of the 1-1-th reflection plate RF1a, the 2-1-th reflection plate RF2a, the third reflection plate RF3, and the fourth reflection plate RF4 may be connected to the first connection pattern CP1 and the second connection pattern CP2 exposed from the first planarization layer 116a and the first passivation layer 115a.

At this time, the first connection pattern CP1 of each of the plurality of sub pixels SP may partially overlap the second connection pattern CP2 of the sub pixel SP of an adjacent row. For example, the first connection pattern CP1 connected to the reflection plate RF(N) of the N-th row and the second connection pattern CP2 connected to the reflection plate RF(M) of the M-th row may be disposed so as to overlap at the boundary of the N-th row and the M-th row. Laser LS is irradiated in a welding area WA in which the first connection pattern CP1 and the second connection pattern CP2 overlap to connect the reflection plates RF of adjacent sub pixels SP.

Referring to FIG. 11A, the first connection pattern CP1 is disposed on the first interlayer insulating layer 113 in the sub pixel SP(N) of the N-th row. The first connection pattern CP1 includes a 1-1-th connection pattern CP1a and a 1-2-th connection pattern CP1b. The 1-1-th connection pattern CP1a is disposed on the first interlayer insulating layer 113 and may be formed on the same layer as the reference line RL with the same material. The 1-2-th connection pattern CP1b is disposed on the second interlayer insulating layer 114 and is connected to the 1-1-th connection pattern CP1a through a contact hole formed in the second interlayer insulating layer 114. The 1-2-th connection pattern CP1b is partially exposed from the first passivation layer 115a and the first planarization layer 116a to be electrically connected to any one of the 1-1-th reflection plate RF1a, the 2-1-th reflection plate RF2a, the third reflection plate RF3, and the fourth reflection plate RF4 on the first planarization layer 116a. The 1-2-th connection pattern CP1b may be formed of the same material on the same layer as the source electrodes and the drain electrodes of the plurality of transistors with the same material.

The second connection pattern CP2 is disposed on the first substrate 110 in the sub pixel SP(M) of the M-th row. The second connection pattern CP2 includes a 2-1-th connection pattern CP2a, and a 2-2-th connection pattern CP2b, and a 2-3-th connection pattern CP2c. The 2-1-th connection pattern CP2a is disposed on the first substrate 110 and may be formed on the same layer as the light shielding layer BSM with the same material. The 2-2-th connection pattern CP2b is disposed on the gate insulating layer 112 and may be connected to the 2-1-th connection pattern CP2a through a contact hole of the buffer layer 111 and the gate insulating layer 112. The 2-2-th connection pattern CP2b may be formed on the same layer as the gate electrodes of the plurality of transistors with the same material. The 2-3-th connection pattern CP2c is disposed on the second interlayer insulating layer 114 and is connected to the 2-2-th connection pattern CP2b through a contact hole formed in the second interlayer insulating layer 114. The 2-3-th connection pattern CP2c is partially exposed from the first passivation layer 115a and the first planarization layer 116a to be electrically connected to any one of the 1-1-th reflection plate RF1a, the 2-1-th reflection plate RF2a, the third reflection plate RF3, and the fourth reflection plate RF4 on the first planarization layer 116a. The 2-3-th connection pattern CP2c may be formed on the same layer as the source electrodes and the drain electrodes of the plurality of transistors with the same material.

The first connection pattern CP1 and the second connection pattern CP2 at least partially overlap to form the welding area WA. The first connection pattern CP1 and the second connection pattern CP2 may be disposed to overlap at the boundary of the N-th row and the M-th row. For example, the 2-1-th connection pattern CP2a, the buffer layer 111, the gate insulating layer 112, the 2-2-th connection pattern CP2b, the first interlayer insulating layer 113, the 1-2-th connection pattern CP1b, and the second interlayer insulating layer 114 are sequentially disposed on the first substrate 110 at the boundary of the N-th row and the M-th row. The 1-2-th connection pattern CP1b and the 2-3-th connection pattern CP2c which are the top layers of the connection patterns may be disposed to be spaced apart from the welding area WA at the boundary of the N-th row and the M-th row. Accordingly, the 1-1-th connection pattern CP1a of the first connection pattern CP1 and the 2-1-th connection pattern CP2a and the 2-2-th connection pattern CP2b of the second connection pattern CP2 overlap to form the welding area WA.

A portion of at least some of the plurality of insulating layers formed on the first connection pattern CP1 and the second connection pattern CP2 overlapping the welding area WA may be open. For example, an opening is formed in a portion of the first planarization layer 116a which overlaps the welding area WA so that the first passivation layer 115a below the first planarization layer 116a may be exposed.

An opening which overlaps the welding area WA may be formed in only one of the adhesive layer AD and the second planarization layer 116b which are formed on the first planarization layer 116a. If the bank BB is formed on the second planarization layer 116b while forming the opening on both the adhesive layer AD and the second planarization layer 116b, a depth of the opening on the welding area WA is large so that the bank BB is not properly removed from the lower portion of the opening. Therefore, a residual film may be formed. In this case, energy loss of the laser LS irradiated into the welding area WA in the bank BB formed of the black material may be caused. Therefore, when a residual film of the bank BB is present, in order to perform the welding process of the first connection pattern CP1 and the second connection pattern CP2, laser LS with a higher intensity needs to be irradiated. Therefore, the periphery of the welding area WA may be damaged by the laser LS with the increased intensity. Therefore, the opening corresponding to the welding area WA is formed in only one of the adhesive layer AD and the second planarization layer 116b to form the opening to have a smaller depth and reduce the residual film of the bank BB in the opening. Accordingly, even though in FIGS. 11A and 11B, it is illustrated that the opening is formed in the second planarization layer 116b, an opening may be formed in the adhesive layer AD and the second planarization layer 116b may be formed on the welding area WA, but is not limited thereto.

An opening overlapping the welding area WA may be formed in the bank BB. As described above, the bank BB may be formed of a black material and when the bank BB covers the welding area WA, it may be difficult to normally irradiate the laser LS onto the welding area WA. Accordingly, the opening is formed in the bank BB formed on the first connection pattern CP1 and the second connection pattern CP2 to smoothly irradiate the laser LS onto the welding area WA.

In the meantime, even though in FIGS. 11A and 11B, it is illustrated that at least a part of the first passivation layer 115a which overlaps the welding area WA is open, the present disclosure is not limited thereto.

Next, referring to FIG. 11A, the process (2) of connecting the first connection pattern CP1 and the second connection pattern CP2 by irradiating the laser LS onto the welding area WA may be performed. When the welding process is performed, at least the first interlayer insulating layer 113 of the first interlayer insulating layer 113, the gate insulating layer 112, and the buffer layer 111 of the welding area WA is open and the first connection pattern CP1 and the second connection pattern CP2 may be electrically connected.

Therefore, the reflection plate RF(N) of the sub pixel SP(N) of the N-th row may be electrically connected to the reflection plate RF(M) of the sub pixel SP(M) of the adjacent M-th row through the first connection pattern CP1 and the second connection pattern CP2. Further, the light emitting diode 130 of the sub pixel SP(N) of the N-th row may be normally driven using the pixel circuit of the sub pixel SP(M) of the M-th row. In this case, a driving current of driving the light emitting diode 130 of the N-th row and a driving current of driving the light emitting diode 130 of the M-th row may flow through the sixth transistor T6 of the sub pixel SP(M) of the M-th row.

At this time, the 1-2-th connection pattern CP1b and the 2-3-th connection pattern CP2c which are formed of the same material as the source electrode and the drain electrode, among the configurations of the first connection pattern CP1 and the second connection pattern CP2, are not disposed in the welding area WA. Therefore, the welding process may be more easily performed. For example, the 1-1-th connection pattern CP1a disposed on the same layer as the reference line RL may be formed of molybdenum (Mo) with a thickness of approximately 2000 Å and the 2-2-th connection pattern CP2b disposed on the same layer as the plurality of gate electrodes may be formed of molybdenum (Mo) with a thickness of approximately 3000 Å. Further, the 1-2-th connection pattern CP1b and the 2-3-th connection pattern CP2c disposed on the same layer as the plurality of source electrodes and the plurality of drain electrodes with the same material may be formed with a triple-layered structure of titanium/aluminum/titanium (Ti/Al/Ti) with a thickness of approximately 8000 Å.

If the 1-2-th connection pattern CP1b or the 2-3-th connection pattern CP2c are disposed to overlap the welding area WA, the welding process may be performed by irradiating laser LS with a stronger intensity. The 1-2-th connection pattern CP1b or the 2-3-th connection pattern CP2c have a relatively larger thickness, so that in order for the energy of the laser LS to reach the configurations below the 1-2-th connection pattern CP1b and the 2-3-th connection pattern CP2c, laser LS with a stronger intensity needs to be irradiated. Therefore, in the welding area WA, the 1-2-th connection pattern CP1b and the 2-3-th connection pattern CP2c having a relatively larger thickness are not disposed, but 1-1-th connection pattern CP1a or the 2-2-th connection pattern CP2b having a relatively smaller thickness are disposed so that the welding process may proceed with laser LS with a weaker intensity.

In the meantime, a plurality of layers which forms the first connection pattern CP1 and the second connection pattern CP2 is formed to have a smaller size toward the upper portion so that the first connection pattern CP1 and the second connection pattern CP2 may be protected from the static electricity. Among the plurality of layers included in the first connection pattern CP1 and the second connection pattern CP2, an upper layer may be disposed to overlap an inner area of a lower layer. The upper layer may be disposed so as to overlap only the inner area of the lower layer so that the upper layer does not cover the edge of the lower layer.

Static electricity may be introduced into the display device 100 due to various reasons. For example, during the process of manufacturing the display device 100, the display panel PN and some configurations are in contact with each other to generate the static electricity due to induction/separation charging. Static electricity entering the display panel PN causes some conductive layers to burst at the edge to cause the conductive layer to short from another conductive layer.

For example, when there is only the normal sub pixels SP so that the welding process is not performed and the static electricity does not enter, the 2-2-th connection pattern CP2b and the 1-1-th connection pattern CP1a may be insulated from each other with the first interlayer insulating layer 113 therebetween. In contrast, when the static electricity enters to cause the burst at the edge of the 2-2-th connection pattern CP2b, the 2-2-th connection pattern CP2b and the 1-1-th connection pattern CP1a are connected so that the normal sub pixels SP may be connected to each other, resulting in the defect of the sub pixel SP.

Therefore, in the display device 100 according to the exemplary embodiment of the present disclosure, edges of the plurality of layers of the first connection pattern CP1 and the second connection pattern CP2 are formed so as not to overlap the upper layers of the plurality of layers. Therefore, even though the burst is caused at the edge of each layer due to the static electricity, the short problem may not be generated.

For example, among the plurality of layers which forms the first connection pattern CP1 and the second connection pattern CP2, the 2-1-th connection pattern CP2a disposed on the bottom is formed to have the largest size and other layers disposed on the 2-1-th connection pattern CP2a may be formed to have smaller sizes toward the top. The 2-2-th connection pattern CP2b on the 2-1-th connection pattern CP2a may be formed to have a smaller size than the 2-1-th connection pattern CP2a and an edge of the 2-2-th connection pattern CP2b may be formed to overlap an area in the 2-1-th connection pattern CP2a. The 1-1-th connection pattern CP1a on the 2-2-th connection pattern CP2b may be formed to have a smaller size than the 2-2-th connection pattern CP2b and an edge of the 1-1-th connection pattern CP1a may be disposed in an area in which the 2-2-th connection pattern CP2b is disposed. The 2-3-th connection pattern CP2c may be formed to have a smaller size than the 2-2-th connection pattern CP2b and an edge of the 2-3-th connection pattern CP2c may overlap inside the 2-3-th connection pattern CP2c. The 1-2-th connection pattern CP1b may be formed to have a smaller size than the 1-1-th connection pattern CP1a and an entire edge of the 1-2-th connection pattern CP1b may overlap the 1-1-th connection pattern CP1a. Accordingly, an edge of an upper layer is disposed at the outside of the edge of the lower layer so that short problem caused by the burst problem at the edge of each layer may be reduced.

Next, after completing the process (2), a defective sub pixel SP which causes luminance or color abnormality may be redetected by inspecting the display panel PN. When it is determined that the re-darkening is necessary in the sub pixel SP on which the process (2) is performed, the process (3) may be performed. The process (3) is a process of cutting a reflection plate RF of a cutting area CA to separate again reflection plates RF which are connected by the first connection pattern CP1 and the second connection pattern CP2.

Referring to FIGS. 10 to 11B, the cutting area CA is an area of the protrusion RFP of the reflection plate RF which does not overlap the first connection pattern CP1 and the second connection pattern CP2. In the cutting area CA, only the protrusion RFP among the first connection pattern CP1, the second connection pattern CP2, and the protrusion RFP of the reflection plate RF may be disposed. The protrusion RFP may be cut from at least one of a cutting area CA adjacent to the first connection pattern CP1 and a cutting area CA adjacent to the second connection pattern CP2. Therefore, the protrusion RFP of the cutting area CA is cut to separate again reflection plates RF which are connected by the first connection pattern CP1 and the second connection pattern CP2.

For example, when the first connection pattern CP1 and the second connection pattern CP2 are connected to each other by the welding process and the reflection plate RF(N) of the N-th row and the reflection plate RF(M) of the M-th row are electrically connected, the protrusion RFP of the reflection plate RF adjacent to the first connection pattern CP1 and the second connection pattern CP2 is cut to electrically separate the reflection plate RF(N) of the N-th row and the reflection plate RF(M) of the M-th row. Accordingly, the reflection plates RF which are electrically connected by the first connection pattern CP1 and the second connection pattern CP2 are separated again to re-darken the defective sub pixel SP.

Accordingly, in the display device 100 according to the exemplary embodiment of the present disclosure, the welding process is performed on the second capacitor C2 connected between the sixth gate electrode GE6 and the sixth source electrode SE6 of the sixth transistor T6 to darken the defective sub pixel SP. The second capacitor C2 is connected between the sixth gate electrode GE6 and the sixth source electrode SE6 of the sixth transistor T6. When the pixel circuit is defective, the welding process is performed on the second capacitor C2 to suppress the bright spot problem due to the defective pixel circuit. when laser LS is irradiated onto the second capacitor C2, electrodes which configure the second capacitor C2 are in contact with each other to connect the sixth gate electrode GE6 and the sixth source electrode SE6 of the sixth transistor T6 which serves as a driving transistor. In this case, a voltage difference Vgs between the sixth gate electrode GE6 and the sixth source electrode SE6 is 0 V so that the pixel circuit cannot cause the light emitting diode 130 to emit light. Accordingly, in the display device 100 according to the exemplary embodiment of the present disclosure, the welding process is performed only on the second capacitor C2 without performing complex laser (LS) cutting and welding process to easily darken the defective pixel circuit.

In the display device 100 according to the exemplary embodiment of the present disclosure, the reflection plate RF of the defective sub pixel SP and a reflection plate RF of a normal sub pixel SP which is adjacent to the defective sub pixel SP are connected by the welding process. Therefore, the light emitting diode 130 of the defective sub pixel SP may be driven by the pixel circuit of the normal sub pixel SP. First, in each of the plurality of sub pixels SP, a reflection plate RF which covers the most area of the plurality of sub pixels SP and reflects light emitted from the light emitting diode 130 above the substrate is disposed. At this time, the 1-1-th reflection plate RF1a, the 2-1-th reflection plate RF2a, the third reflection plate RF3, and the fourth reflection plate RF4 among the reflection plates RF serve as electrodes which connect the first electrode 134 of the light emitting diode 130 and the pixel circuit. Therefore, the 1-1-th reflection plate RF1a, the 2-1-th reflection plate RF2a, the third reflection plate RF3, and the fourth reflection plate RF4 of the defective sub pixel SP are connected to a 1-1-th reflection plate RF1a, a 2-1-th reflection plate RF2a, a third reflection plate RF3, and a fourth reflection plate RF4 of an adjacent row. Accordingly, the light emitting diode 130 of the defective sub pixel SP may be electrically connected to a pixel circuit of an adjacent sub pixel SP.

At this time, the first connection pattern CP1 and the second connection pattern CP2 which overlap with the first interlayer insulating layer 113 therebetween are disposed in an area between one pair of adjacent reflection plates RF and a welding process for connecting the first connection pattern CP1 and the second connection pattern CP2 is performed to connect the pair of adjacent reflection plates RF. The first connection pattern CP1 and the second connection pattern CP2 which overlap each other may be connected to different reflection plates RF. The first connection pattern CP1 may be connected to one of one pair of adjacent reflection plates RF and the second connection pattern CP2 may be connected to the other reflection plates RF. The welding process is performed by irradiating laser LS onto the welding area WA in which the first connection pattern CP1 and the second connection pattern CP2 overlap to electrically connect one reflection plate RF connected to the first connection pattern CP1 and the other reflection plate RF connected to the second connection pattern CP2. Accordingly, the first electrode 134 of the light emitting diode 130 of the defective sub pixel SP may be electrically connected to the first electrode 134 of the light emitting diode 130 of the normal sub pixel SP by means of the first connection pattern CP1, the second connection pattern CP2, and the reflection plate RF which are connected to each other. Further, the light emitting diode 130 of the defective sub pixel SP and the light emitting diode 130 of the normal sub pixel SP may be driven together with one pixel circuit. Accordingly, in the display device 100 according to the exemplary embodiment of the present disclosure, the light emitting diode 130 may be easily connected to the pixel circuit which is normally driven by only one welding process using the reflection plate RF, the first connection pattern CP1, and the second connection pattern CP2 and the repair process may be simplified.

In the display device 100 according to the exemplary embodiment of the present disclosure, edges of the plurality of layers included in the first connection pattern CP1 and the second connection pattern CP2 are formed so as not to cover an edge of the lower layer. Accordingly, the short problem of the first connection pattern CP1 and the second connection pattern CP2 due to the static electricity may be suppressed. In some cases, a burst problem is caused at edge of each conductive layer due to the static electricity. In this case, when the burst occurs at the edge of the lower layer, a short problem between a lower layer and an upper layer which covers the edge of the lower layer may be caused. The first connection pattern CP1 and the second connection pattern CP2 between the normal sub pixels SP need to be separated with an insulating layer therebetween, however the first connection pattern CP1 and the second connection pattern CP2 are connected due to the static electricity to cause another problem. Therefore, the plurality of layers of the first connection pattern CP1 and the second connection pattern CP2 which are disposed to overlap each other is formed so as not to cover an edge of the lower layer to reduce the short problem due to the static electricity. For example, the 2-2-th connection pattern CP2b is formed to have a smaller size than the 2-1-th connection pattern CP2a disposed on the bottom to overlap only the inside of the 2-1-th connection pattern CP2a. Therefore, the 2-2-th connection pattern CP2b may be disposed so as not to cover the edge of the 2-1-th connection pattern CP2a. Accordingly, the plurality of layers which forms the first connection pattern CP1 and the second connection pattern CP2 is formed to have a smaller size toward the top so that the upper layer may be designed so as not to cover the edge of the lower layer.

In the display device 100 according to the exemplary embodiment of the present disclosure, a conductive layer having a relatively larger thickness is removed from the welding area WA which connects the reflection plates RF so that the welding process may be easily performed with a laser with a lower output. For example, the 1-2-th connection pattern CP1b and the 2-3-th connection pattern CP2c which are formed to be relatively thick, among the plurality of conductive layers of the first connection pattern CP1 and the second connection pattern CP2 disposed in the welding area WA, may be disposed to be spaced apart from the welding area WA. Further, in the welding area WA, the 2-2-th connection pattern CP2b having a relatively smaller thickness is disposed on the top to reduce the intensity of laser and reduce the damage of the periphery of the welding area WA.

In the display device 100 according to the exemplary embodiment of the present disclosure, a cutting process of separating the reflection plate RF from the first connection pattern CP1 or the second connection pattern CP2 is performed in the sub pixel SP required to be re-darkened to perform the re-darkening. The reflection plate RF of the defective sub pixel SP may be connected to the reflection plate RF of the adjacent sub pixel SP through the first connection pattern CP1 and the second connection pattern CP2. However, when it is determined that the re-darkening is necessary after the repair, a protrusion RFP of the cutting area CA spaced apart from the first connection pattern CP1 and the second connection pattern CP2, among the protrusions RFP of the reflection plate RF may be cut. Therefore, the protrusion RFP is cut from the cutting area CA to separate the protrusion RFP and the reflection plate RF so that the reflection plate RF is separated from the first connection pattern CP1 and the second connection pattern CP2 to re-darken the defective sub pixel SP.

The exemplary embodiments of the present disclosure can also be described as follows:

Although the exemplary embodiments of the present disclosure have been described in detail with reference to the accompanying drawings, the present disclosure is not limited thereto and is defined by the appended claims.

## Claims

1. A display device, comprising:
a first substrate (110) in which a plurality of sub pixels (SP) including at least one defective sub pixel (SP) and a plurality of normal sub pixels (SP) is defined;
a light emitting diode (130) disposed in each of the plurality of sub pixels (SP);
a plurality of transistors disposed in each of the plurality of sub pixels (SP), including a driving transistor having a source electrode (SE) connected to a first electrode (134) of the light emitting diode (130);
a capacitor (C) which includes a plurality of capacitor electrodes connected to a gate electrode (GE) and the source electrode (SE) of the driving transistor; and
a reflection plate (RF) disposed in each of the plurality of sub pixels (SP) and electrically connected to the first electrode (134),
**characterised in that**,
in the defective sub pixel (SP), the capacitor electrodes of the capacitor (C) are in contact with each other.

2. The display device according to claim 1, wherein in the defective sub pixel (SP), the gate electrode (GE) and the source electrode (SE) of the driving transistor are electrically connected through the plurality of capacitor electrodes.

3. The display device according to claim 1 or 2, wherein in the plurality of normal sub pixels (SP), the plurality of capacitor electrodes is spaced apart from each other with an insulating layer therebetween.

4. The display device according to claim 1, 2 or 3, wherein among the plurality of normal sub pixels (SP), the reflection plates (RF) of one pair of adjacent normal sub pixels (SP) are insulated and the reflection plate (RF) of the defective sub pixel (SP) is electrically connected to one of the reflection plates (RF) of the plurality of normal sub pixels (SP) adjacent to the defective sub pixel (RF).

5. The display device according to any one of the preceding claims, wherein the first electrode (134) of the light emitting diode (130) of the defective sub pixel (SP) is electrically connected to the driving transistors of the plurality of normal sub pixels (SP).

6. The display device according to any one of the preceding claims , further comprising:
a first connection pattern (CP1) connected at one edge of the reflection plate (RF) of each of the plurality of sub pixels (SP); and
a second connection pattern (CP2) connected at the other edge of the reflection plate (RF) of each of the plurality of sub pixels (SP);
wherein the first connection pattern (CP1) and the second connection pattern (CP2) which are connected to different reflection plates (RF) among the reflection plates (RF) overlap at a boundary between the plurality of sub pixels (SP) to form a welding area (WA).

7. The display device according to claim 6, wherein the first connection pattern (CP1) includes:
a 1-1-th connection pattern (CP1a) disposed on the first substrate (110); and
a 1-2-th connection pattern (CP1b) which is disposed on the 1-1-th connection pattern (CP1a) and has a thickness larger than that of the 1-1-th connection pattern (CP1a),
the second connection pattern (CP2) includes:
a 2-1-th connection pattern (CP2a) disposed between the first substrate (110) and the first connection pattern (CP1);
a 2-2-th connection pattern (CP2b) disposed between the 2-1-th connection pattern (CP2a) and the first connection pattern (CP1); and
a 2-3-th connection pattern (CP2c) which is disposed on the 2-2-th connection pattern (CP2b) and has a thickness larger than that of the 2-2-th connection pattern (CP2b), and
the 1-2-th connection pattern (CP1a) and the 2-3-th connection pattern (CP2c) are connected to the reflection plate (RF).

8. The display device according to claim 7, wherein the 1-1-th connection pattern (CP1a), the 2-1-th connection pattern (CP2a), and the 2-2-th connection pattern (CP2b) overlap the welding area (WA) and the 1-2-th connection pattern (CP1b) and the 2-3-th connection pattern (CP2c) are disposed to be spaced apart from the welding area (WA).

9. The display device according to claim 7 or 8, wherein the first connection pattern (CP1) and the second connection pattern (CP2) are disposed to be spaced apart from each other with an insulating layer therebetween at the boundary of one pair of adjacent normal sub pixels (SP).

10. The display device according to claim 7, 8 or 9, wherein the 1-1-th connection pattern (CP1a) is in contact with the 2-2-th connection pattern (CP2b) in the welding area (WA) disposed at the boundary of the defective sub pixel (SP) and the normal sub pixel (SP).

11. The display device according to claim 7, 8, 9, or 10, wherein the 1-2-th connection pattern (CP1b) is disposed in an inner area of the 1-1-th connection pattern (CP1a),an inner area of the 2-1-th connection pattern (CP2a), and an inner area of the 2-2-th connection pattern (CP2b) and the 2-2-th connection pattern (CP2b) is disposed in an inner area of the 2-1-th connection pattern (CP2a) and the 2-3-th connection pattern (CP2c) is disposed in an inner area of the 2-2-th connection pattern (CP2b).

12. The display device according to claim 10 or 11, wherein an entire edge of the 1-2-th connection pattern (CP1b) overlaps the 1-1-th connection pattern (CP1a), an entire edge of the 2-2-th connection pattern (CP2b) overlaps the 2-1-th connection pattern (CP2a), and an entire edge of the 2-3-th connection pattern (CP2c) overlaps the 2-2-th connection pattern (CP2b).

13. The display device according to any one of the preceding claims 6 -12, wherein the reflection plate (RF) further includes a protrusion (RFP) which protrudes from each of one edge and the other edge to be connected to the first connection pattern (CP1) and the second connection pattern (CP2) and the protrusion (RFP) includes a cutting area (CA) which does not overlap the first connection pattern (CP1) and the second connection pattern (CP2) and/or at least some of the protrusions (RFP) of the plurality of sub pixels (SP) is cut from the cutting area (CA) to be separated from the reflection plate (RF).

14. The display device according to any one of the preceding claims, further comprising:
a plurality of gate driving areas (GA) disposed between the plurality of sub pixels (SP); and
a gate driver (GD) disposed in the plurality of gate driving areas (GA) and includes a plurality of gate driving transistors.

15. The display device according to claim 14, wherein the plurality of transistors of the plurality of sub pixels (SP) includes an active layer (ACT) which is formed of any one of oxide semiconductor, amorphous silicon, and polysilicon and the plurality of gate driving transistors of the gate driver includes an active layer (ACT) which is formed of any one of oxide semiconductor, amorphous silicon, and polysilicon and/or the active layers of the plurality of gate driving transistors of the gate driver are formed of different materials.

## Patentansprüche

1. Anzeigevorrichtung, die umfasst:
ein erstes Substrat (110), in dem mehrere Unterpixel (SP), die mindestens ein fehlerhaftes Unterpixel (SP) und mehrere normale Unterpixel (SP) umfassen, definiert sind;
eine Leuchtdiode (130), die in jedem der mehreren Unterpixel (SP) angeordnet ist;
mehrere Transistoren, die in jedem der mehreren Unterpixel (SP) angeordnet sind und einen Ansteuerungstransistor, dessen Source-Elektrode (SE) mit einer ersten Elektrode (134) der Leuchtdiode (130) verbunden ist, enthalten;
einen Kondensator (C), der mehrere Kondensatorelektroden enthält, die mit einer Gate-Elektrode (GE) und der Source-Elektrode (SE) des Ansteuerungstransistors verbunden sind; und
eine Reflexionsplatte (RF), die in jedem der mehreren Unterpixel (SP) angeordnet ist und mit der ersten Elektrode (134) elektrisch verbunden ist,
**dadurch gekennzeichnet, dass**
in dem fehlerhaften Unterpixel (SP) die Kondensatorelektroden des Kondensators (C) miteinander in Kontakt sind.

2. Anzeigevorrichtung nach Anspruch 1, wobei in dem fehlerhaften Unterpixel (SP) die Gate-Elektrode (GE) und die Source-Elektrode (SE) des Ansteuerungstransistors durch die mehreren Kondensatorelektroden elektrisch verbunden sind.

3. Anzeigevorrichtung nach Anspruch 1 oder 2, wobei in den mehreren normalen Unterpixeln (SP) die mehreren Kondensatorelektroden mit einer Isolierschicht zwischen ihnen voneinander beabstandet sind.

4. Anzeigevorrichtung nach Anspruch 1, 2 oder 3, wobei unter den mehreren normalen Unterpixeln (SP) die Reflexionsplatten (RF) eines Paars benachbarter normaler Unterpixel (SP) isoliert sind und die Reflexionsplatte (RF) des fehlerhaften Unterpixels (SP) mit einer der Reflexionsplatten (RF) der mehreren normalen Unterpixel (SP) benachbart zu dem fehlerhaften Unterpixel (RF) elektrisch verbunden ist.

5. Anzeigevorrichtung nach einem der vorhergehenden Ansprüche, wobei die erste Elektrode (134) der Leuchtdiode (130) des fehlerhaften Unterpixels (SP) mit den Ansteuerungstransistoren der mehreren normalen Unterpixel (SP) elektrisch verbunden ist.

6. Anzeigevorrichtung nach einem der vorhergehenden Ansprüche, die ferner umfasst:
ein erstes Verbindungsmuster (CP1), das mit einem Rand der Reflexionsplatte (RF) jedes der mehreren Unterpixel (SP) verbunden ist; und
ein zweites Verbindungsmuster (CP2), das an dem anderen Rand der Reflexionsplatte (RF) jedes der mehreren Unterpixel (SP) verbunden ist;
wobei sich das erste Verbindungsmuster (CP1) und das zweite Verbindungsmuster (CP2), die mit verschiedenen Reflexionsplatten (RF) unter den Reflexionsplatten (RF) verbunden sind, an einer Grenze zwischen den mehreren Unterpixeln (SP) überdecken, um einen Schweißbereich (WA) zu bilden.

7. Anzeigevorrichtung nach Anspruch 6, wobei das erste Verbindungsmuster (CP1) enthält:
ein 1-1-tes Verbindungsmuster (CPla), das auf dem ersten Substrat (110) angeordnet ist; und
ein 1-2-tes Verbindungsmuster (CP1b), das auf dem 1-1-ten Verbindungsmuster (CP1a) angeordnet ist und eine Dicke besitzt, die größer als die des 1-1-ten Verbindungsmusters (CP1a) ist,
wobei das zweite Verbindungsmuster (CP2) enthält:
ein 2-1-tes Verbindungsmuster (CP2a), das zwischen dem ersten Substrat (110) und dem ersten Verbindungsmuster (CP1) angeordnet ist;
ein 2-2-tes Verbindungsmuster (CP2b), das zwischen dem 2-1-ten Verbindungsmuster (CP2a) und dem ersten Verbindungsmuster (CP1) angeordnet ist; und
ein 2-3-tes Verbindungsmuster (CP2c), das auf dem 2-2-ten Verbindungsmuster (CP2b) angeordnet ist und eine Dicke besitzt, die größer als die des 2-2-ten Verbindungsmusters (CP2b) ist, und
das 1-2-te Verbindungsmuster (CPla) und das 2-3-te Verbindungsmuster (CP2c) mit der Reflexionsplatte (RF) verbunden sind.

8. Anzeigevorrichtung nach Anspruch 7, wobei das 1-1-te Verbindungsmuster (CP1a) das 2-1-te Verbindungsmuster (CP2a) und das 2-2-te Verbindungsmuster (CP2b) den Schweißbereich (WA) überdecken und das 1-2-te Verbindungsmuster (CP1b) und das 2-3-te Verbindungsmuster (CP2c) so angeordnet sind, dass sie von dem Schweißbereich (WA) beabstandet sind.

9. Anzeigevorrichtung nach Anspruch 7 oder 8, wobei das erste Verbindungsmuster (CP1) und das zweite Verbindungsmuster (CP2) an der Grenze eines Paars benachbarter normaler Unterpixel (SP) so angeordnet sind, dass sie voneinander mit einer Isolierschicht zwischen ihnen beabstandet sind.

10. Anzeigevorrichtung nach Anspruch 7, 8 oder 9, wobei das 1-1-te Verbindungsmuster (CP1a) mit dem 2-2-ten Verbindungsmuster (CP2b) in dem Schweißbereich (WA), der an der Grenze des fehlerhaften Unterpixels (SP) und des normalen Unterpixels (SP) angeordnet ist, in Kontakt ist.

11. Anzeigevorrichtung nach Anspruch 7, 8, 9 oder 10, wobei das 1-2-te Verbindungsmuster (CP1b) in einem inneren Bereich des 1-1-ten Verbindungsmusters (CP1a), einem inneren Bereich des 2-1-ten Verbindungsmusters (CP2b) und einem inneren Bereich des 2-2-ten Verbindungsmusters (CP2b) angeordnet ist und das 2-2-te Verbindungsmuster (CP2b) in einem inneren Bereich des 2-1-ten Verbindungsmusters (CP2a) angeordnet ist und das 2-3-te Verbindungsmuster in einem inneren Bereich des 2-2-ten Verbindungsmusters (CP2b) angeordnet ist.

12. Anzeigevorrichtung nach Anspruch 10 oder 11, wobei ein gesamter Rand des 1-2-ten Verbindungsmusters (CP1b) das 1-1-te Verbindungsmuster (CP1a) überdeckt, ein gesamter Rand des 2-2-ten Verbindungsmusters (CP2b) das 2-1-te Verbindungsmuster (CP2a) überdeckt und ein gesamter Rand des 2-3-ten Verbindungsmusters (CP2c) das 2-2-te Verbindungsmuster (CP2b) überdeckt.

13. Anzeigevorrichtung nach einem der vorhergehenden Ansprüche 6-12, wobei die Reflexionsplatte (RF) ferner einen Vorsprung (RFP) enthält, der von jedem des einen Rands und des anderen Rands vorsteht, um mit dem ersten Verbindungsmuster (CP1) und dem zweiten Verbindungsmuster (CP2) verbunden zu sein, und der Vorsprung (RFP) einen Schnittbereich (CA) enthält, der das erste Verbindungsmuster (CP1) und das zweite Verbindungsmuster (CP2) nicht überdeckt, und/oder zumindest einige der Vorsprünge (RFP) der mehreren Unterpixel (SP) aus dem Schnittbereich (CA) ausgeschnitten sind, um von der Reflexionsplatte (RF) getrennt zu sein.

14. Anzeigevorrichtung nach einem der vorhergehenden Ansprüche, die ferner umfasst:
mehrere Gate-Ansteuerungsbereiche (GA), die zwischen den mehreren Unterpixeln (SP) angeordnet sind; und
eine Gate-Ansteuerung (GD), die in den mehreren Gate-Ansteuerungsbereichen (GA) angeordnet ist und mehrere Gate-Ansteuerungstransistoren enthält.

15. Anzeigevorrichtung nach Anspruch 14, wobei die mehreren Transistoren der mehreren Unterpixel (SP) eine aktive Schicht (ACT) enthalten, die aus einem beliebigen von einem Oxidhalbleiter, amorphem Silizium und Polysilizium gebildet ist, und die mehreren Gate-Ansteuerungstransistoren der Gate-Ansteuerung eine aktive Schicht (ACT) enthalten, die aus einem beliebigen von einem Oxidhalbleiter, amorphem Silizium und Polysilizium gebildet ist, und/oder die aktiven Schichten der mehreren Gate-Ansteuerungstransistoren der Gate-Ansteuerung aus verschiedenen Materialien gebildet sind.

## Revendications

1. Dispositif d'affichage, comportant :
un premier substrat (110) dans lequel une pluralité de sous-pixels (SP) incluant au moins un sous-pixel défectueux (SP) et une pluralité de sous-pixels normaux (SP) est définie ;
une diode électroluminescente (130) disposée dans chaque sous-pixel de la pluralité de sous-pixels (SP) ;
une pluralité de transistors disposés dans chaque sous-pixel de la pluralité de sous-pixels (SP), incluant un transistor d'attaque ayant une électrode de source (SE) connectée à une première électrode (134) de la diode électroluminescente (130) ;
un condensateur (C) qui inclut une pluralité d'électrodes de condensateur connectées à une électrode de grille (GE) et à l'électrode de source (SE) du transistor d'attaque ; et
une plaque de réflexion (RF) disposée dans chaque sous-pixel de la pluralité de sous-pixels (SP) et électriquement connectée à la première électrode (134),
**caractérisé en ce que**
dans le sous-pixel défectueux (SP), les électrodes de condensateur du condensateur (C) sont en contact l'une avec l'autre.

2. Dispositif d'affichage selon la revendication 1, dans lequel, dans le sous-pixel défectueux (SP), l'électrode de grille (GE) et l'électrode de source (SE) du transistor d'attaque sont électriquement connectées via la pluralité d'électrodes de condensateur.

3. Dispositif d'affichage selon la revendication 1 ou 2, dans lequel, dans la pluralité de sous-pixels normaux (SP), les électrodes de la pluralité d'électrodes de condensateur sont espacées les unes des autres avec une couche d'isolation entre celles-ci.

4. Dispositif d'affichage selon la revendication 1, 2 ou 3, dans lequel parmi la pluralité de sous-pixels normaux (SP), les plaques de réflexion (RF) d'une paire de sous-pixels normaux (SP) adjacents sont isolées et la plaque de réflexion (RF) du sous-pixel défectueux (SP) est électriquement connectée à l'une des plaques de réflexion (RF) de la pluralité de sous-pixels normaux adjacents au sous-pixel défectueux (RF).

5. Dispositif d'affichage selon l'une quelconque des revendications précédentes, dans lequel la première électrode (134) de la diode électroluminescente (130) du sous-pixel défectueux (SP) est électriquement connectée aux transistors d'attaque de la pluralité de sous-pixels normaux (SP).

6. Dispositif d'affichage selon l'une quelconque des revendications précédentes, comportant en outre :
un premier motif de connexion (CP1) connecté sur un bord de la plaque de réflexion (RF) de chaque sous-pixel de la pluralité de sous-pixels (SP) ; et
un second motif de connexion (CP2) connecté sur l'autre bord de la plaque de réflexion (RF) de chaque sous-pixel de la pluralité de sous-pixels (SP) ;
dans lequel le premier motif de connexion (CP1) et le second motif de connexion (CP2) qui sont connectés à différentes plaques de réflexion (RF) parmi les plaques de réflexion (RF) se chevauchent à une frontière entre la pluralité de sous-pixels (SP) pour former une zone de soudage (WA).

7. Dispositif d'affichage selon la revendication 6, dans lequel le premier motif de connexion (CP1) inclut :
un 1-1^{ème} motif de connexion (CP1a) disposé sur le premier substrat (110) ; et
un 1-2^{ème} motif de connexion (CP1b) qui est disposé sur le 1-1^{ème} motif de connexion (CP1a) et a une épaisseur supérieure à celle du 1-1^{ème} motif de connexion (CP1a),
le second motif de connexion (CP2) inclut :
un 2-1^{ème} motif de connexion (CP2a) disposé entre le premier substrat (110) et le premier motif de connexion (CP1) ;
un 2-2^{ème} motif de connexion (CP2b) disposé entre le 2-1^{ème} motif de connexion (CP2a) et le premier motif de connexion (CP1) ; et
un 2-3^{ème} motif de connexion (CP2c) qui est disposé sur le 2-2^{ème} motif de connexion (CP2b) et a une épaisseur supérieure à celle du 2-2^{ème} motif de connexion (CP2b), et
le 1-2^{ème} motif de connexion (CP1a) et le 2-3^{ème} motif de connexion (CP2c) sont connectés à la plaque de réflexion (RF).

8. Dispositif d'affichage selon la revendication 7, dans lequel le 1-1^{ème} motif de connexion (CP1a), le 2-1^{ème} motif de connexion (CP2a) et le 2-2^{ème} motif de connexion (CP2b) chevauchent la zone de soudage (WA) et le 1-2^{ème} motif de connexion (CP1b) et le 2-3^{ème} motif de connexion (CP2c) sont disposés de manière à être espacés de la zone de soudage (WA).

9. Dispositif d'affichage selon la revendication 7 ou 8, dans lequel le premier motif de connexion (CP1) et le second motif de connexion (CP2) sont disposés de manière à être espacés l'un de l'autre avec une couche d'isolation entre ceux-ci à la frontière d'une paire de sous-pixels normaux (SP) adjacents.

10. Dispositif d'affichage selon la revendication 7, 8 ou 9, dans lequel le 1-1^{ème} motif de connexion (CP1a) est en contact avec le 2-2^{ème} motif de connexion (CP2b) dans la zone de soudage (WA) disposée à la frontière du sous-pixel défectueux (SP) et du sous-pixel normal (SP).

11. Dispositif d'affichage selon la revendication 7, 8, 9 ou 10, dans lequel le 1-2^{ème} motif de connexion (CP1b) est disposé dans une zone intérieure du 1-1^{ème} motif de connexion (CP1a), une zone intérieure du 2-1^{ème} motif de connexion (CP2a) et une zone intérieure du 2-2^{ème} motif de connexion (CP2b), et le 2-2^{ème} motif de connexion (CP2b) est disposé dans une zone intérieure du 2-1^{ème} motif de connexion (CP2a), et le 2-3^{ème} motif de connexion (CP2c) est disposé dans une zone intérieure du 2-2^{ème} motif de connexion (CP2b).

12. Dispositif d'affichage selon la revendication 10 ou 11, dans lequel un bord complet du 1-2^{ème} motif de connexion (CP1b) chevauche le 1-1^{ème} motif de connexion (CP1a), un bord complet du 2-2^{ème} motif de connexion (CP2b) chevauche le 2-1^{ème} motif de connexion (CP2a), et un bord complet du 2-3^{ème} motif de connexion (CP2c) chevauche le 2-2^{ème} motif de connexion (CP2b).

13. Dispositif d'affichage selon l'une quelconque des revendications 6 à 12 précédentes, dans lequel la plaque de réflexion (RF) inclut en outre une saillie (RFP) qui fait saillie à partir de chaque bord parmi un premier bord et le second bord pour être connectée au premier motif de connexion (CP1) et au second motif de connexion (CP2), et la saillie (RFP) inclut une zone de coupe (CA) qui ne chevauche pas le premier motif de connexion (CP1) et le second motif de connexion (CP2) et/ou au moins certaines des saillies (RFP) de la pluralité de sous-pixels (SP) sont coupées à partir de la zone de coupe (CA) pour être séparées de la plaque de réflexion (RF).

14. Dispositif d'affichage selon l'une quelconque des revendications précédentes, comportant en outre :
une pluralité de zones d'attaque de grille (GA) disposées entre la pluralité de sous-pixels (SP) ; et
un circuit d'attaque de grille (GD) disposé dans la pluralité de zones d'attaque de grille (GA) et inclut une pluralité de transistors d'attaque de grille.

15. Dispositif d'affichage selon la revendication 14, dans lequel la pluralité de transistors de la pluralité de sous-pixels (SP) inclut une couche active (ACT) qui est formée d'un élément quelconque parmi un semi-conducteur à oxyde, du silicium amorphe et du polysilicium, et la pluralité de transistors d'attaque de grille du circuit d'attaque de grille inclut une couche active (ACT) qui est formée d'un élément quelconque parmi un semi-conducteur à oxyde, du silicium amorphe et du polysilicium et/ou les couches actives de la pluralité de transistors d'attaque de grille sont formées de différents matériaux.
